# EUROPEAN PATENT SPECIFICATION

(11) **EP 4 284 969 B1**
(45) Date of publication and mention of the grant of the patent: **02.04.2025**
(21) Application number: 22706664.4
(22) Date of filing: 28.01.2022
(51) Int. Cl.: C30B 23/02, C30B 29/12, C30B 35/00, H10K 71/16, H10K 85/50

(54) **METHOD AND APPARATUS FOR DEPOSITION OF A LAYER OF PEROVSKITE ON A SUBSTRATE**
VERFAHREN UND VORRICHTUNG ZUR ABSCHEIDUNG EINER SCHICHT AUS PEROWSKIT AUF EINEM SUBSTRAT
PROCÉDÉ ET APPAREIL DE DÉPÔT D'UNE COUCHE DE PÉROVSKITE SUR UN SUBSTRAT

(30) Priority: 29.01.2021 IT 202100001898
(43) Date of publication of application: 06.12.2023
(73) Proprietor: Consiglio Nazionale Delle Ricerche, 00185 Roma (IT); Kenosistec S.R.L., 20082 Binasco (MI) (IT)
(72) Inventor: ALBERTI, Alessandra, 00185 Roma (IT); SMECCA, Emanuele, 00185 Roma (IT); LA MAGNA, Antonino, 00185 Roma (IT); PERUGINI, Stefano, 20082 Binasco (MI) (IT); ABBIATI, Michele, 20082 Binasco (MI) (IT)
(74) Representative: IP Sextant s.r.l.
(86) International application number: PCT/IB2022/050763
(87) International publication number: WO 2022/162607

(56) References cited:
- US-A1- 2020 024 733
- US-A1- 2020 328 077
- LUIS K. ONO ET AL: "Organometal halide perovskite thin films and solar cells by vapor deposition", JOURNAL OF MATERIALS CHEMISTRY A, vol. 4, no. 18, 1 January 2016 (2016-01-01), GB, pages 6693 - 6713, XP055649780, ISSN: 2050-7488, DOI: 10.1039/C5TA08963H
- ÁVILA JORGE ET AL: "Vapor-Deposited Perovskites: The Route to High-Performance Solar Cell Production?", vol. 1, no. 3, 1 November 2017 (2017-11-01), pages 431 - 442, XP055853320, ISSN: 2542-4351, Retrieved from the Internet <URL:https://www.sciencedirect.com/science/article/pii/S2542435117300211/pdfft?md5=c98a298661690003a039fc0ab7cc8b64&pid=1-s2.0-S2542435117300211-main.pdf> DOI: 10.1016/j.joule.2017.07.014

## Description

### BACKGROUND

The present invention relates to a deposition method, on a substrate, of one or more layers of Perovskite, for example of the type described in [1], having high quality and high technical performance.

The present invention also relates to one apparatus for implementing such a method.

### STATE OF THE ART

The hybrid materials of organic-inorganic Perovskite (H-PSK) have attracted enormous attention in various technical fields such as, for example, the photovoltaic (see references [2] - [5]), LEDs ([6], [7]) and photodetectors ([8] - [10]) field. In the photovoltaic field these materials, thanks to their high absorption of the solar spectrum and excellent diffusion of photo-generated electrons and electron holes [11], have been used for the construction of Perovskite Solar Cells (PSC) capable of reaching, in 11 years only, after Prof. Miyasaka's first publication on the technology, in 2009 [12], unexpected records exceeding 25% in terms of photon-electron conversion efficiency ([13] and [14]).

However, one limitation in the use of these materials is represented by the limited quality of Perovskite layers (hereinafter also PSK) used for photo-conversion, in terms of morphology, crystallinity and density of defects ([15] - [17]). From this point of view, direct experience has been gained on the fundamental role of such features on durability and performance of H-PSK layers and related devices, as described in publications ([18] - [22]) of some of the inventors of the present invention.

The chemical deposition of H-PSK on a substrate, for example by spin coating, is the approach used first which, on one hand, allows a high versatility in the deposition procedure but, on the other hand, does not provide good results in terms of contamination (for example, due to the residual solvent inside the sample or also due to the need for a post-deposition annealing step) and scalability (does not allow to obtain uniform layers on large samples). Although remedies have been explored, particularly to solve the problem of scalability, chemical methods are currently not easily implemented at industrial level, in view of mass production.

Other methods, based on physical vapour deposition (or PVD), also referred to as evaporation or sublimation methods, are inherently free from contaminants and are scalable. An additional advantage of these methods lies in the high reproducibility of the properties of H-PSK layers and in the possibility of reducing their thickness for use in semi-transparent technologies. Many examples can be found in the literature concerning the combination of physical deposition and classical chemical methods, for example by sequencing of PbI₂ (Lead Iodide) by spin-coating and MAI (methylammonium iodide) by evaporation, with further post-deposition treatment, which must be added to ensure a good quality layer.

PVD processes are certainly necessary to bring the technology to market. Starting from the pioneering work of Liu *et al.* [23], which has provided the first evidence of the high stability and performance of H-PSK layers prepared with pure co-evaporation PVD methods compared to pure chemical counterparts, some papers on completely physical techniques applied to the growth of H-PSK ([24] - [26]) have been published. These techniques can be divided into two categories: standard evaporation in high vacuum conditions (HV-PVD, [27]), and sublimation in reduced space (CSS, [28]).

The first method (HV-PVD) requires a vacuum chamber equipped with expensive pumping systems to allow the achievement of high vacuum conditions for ballistic transportation of the species on a substrate. The substrate is placed tens of mm away from the source of the species, to ensure thickness and uniformity of composition. The main drawbacks of this approach are the costs of the initial investment and maintenance, as well as the waste materials that are lost on the walls of the vacuum chamber, with the related need for continuous supply of precursors.

The second method (CSS) is based on a configuration wherein the source faces the substrate at a distance approximately equal to or even less than 1 mm, in order to guarantee a short path for the species to be deposited before reaching the substrate, thus avoiding the need for high vacuum conditions. The drawback in applying the CSS technique for Perovskite deposition (for example, for deposition of MAPbI₃) lies in the need to deposit a first layer of precursor (for example, of PbI₂) with chemical methods, before sublimating the organic species (for example, MAI, [29]) for the formation of the H-PSK layer. It is therefore a difficult to implement technique, requiring a mixed approach.

Other traditional deposition systems, which do not solve the aforementioned drawbacks, are described in US 2020/0024733 A1 and US 2020/0328077 A1. The systems taught in these documents make use of an expansion chamber and a carrier gas for transporting the material that is to be deposited on a substrate within a deposition chamber.

There is therefore a request for further innovation in the field of Perovskite deposition methods on a substrate, to minimize or eliminate the aforementioned drawbacks.

### OBJECTS OF THE INVENTION

The main object of the present invention is, therefore, to improve the state of the art in the field of deposition of one or more Perovskite layers, on at least one substrate.

More particularly, an object of the present invention is to provide a deposition method, on at least one substrate, of at least one layer of at least one PSK precursor, which method, contrary to traditional methods, does not require high vacuum process conditions.

Another object of the present invention is to provide a deposition method, on at least one substrate, of at least one layer of at least one PSK precursor, which method minimizes the waste of the precursor material used.

One further object of the present invention is to provide a deposition method, on at least one substrate, of at least one layer of at least one PSK precursor, which method can be easily controlled as far as the process conditions are concerned.

Still one further object of the present invention is to provide a deposition method, on at least one substrate, of at least one layer of at least one PSK precursor, which method is up-scalable, in terms of the substrate size on which the precursor layer of PSK is deposited.

Yet another object of the present invention is to provide a deposition method, on at least one substrate, of a PSK layer which method does not require mixed approaches, is more simple, more efficient and cheaper to implement, even at an industrial level, than traditional methods.

Not the least object of the present invention is to provide an apparatus for the implementation of the aforementioned methods, which apparatus is cost-effective and easy to implement.

It is a specific object of the present invention one method of deposition of at least one layer of at least one precursor of Perovskite on at least one substrate, through use of at least one deposition chamber, wherein:
- in said at least one deposition chamber at least one inlet mouth and at least one outlet mouth are obtained, which are configured to be selectively opened-closed so as to allow the entrance-exit of at least one gas in-out of said at least one deposition chamber;
- said at least one deposition chamber, at said at least one outlet mouth thereof, is operatively connected to at least one vacuum pump;
- said at least one deposition chamber houses at least one source, said at least one source being configured to receive at least one precursor of said Perovskite without using a carrier gas and said at least one source having at least one delivery mouth configured to let one gas of said at least one precursor of said Perovskite, when it is sublimated into said source, pass directly from said at least one source into said at least one deposition chamber without using a carrier gas; and
- said at least one deposition chamber houses at least one supporting device for said at least one substrate, said supporting device being configured to support said substrate between at least one working position, wherein said at least one substrate is aligned with said at least one delivery mouth of said at least one source, at a preset deposition distance therefrom, and one resting position, wherein it is spaced apart from said at least one delivery mouth of said at least one source, at a distance greater than said preset deposition distance;
and wherein
- said at least one substrate is supported in said at least one deposition chamber and said at least one precursor of said Perovskite is charged into said at least one source of said at least one deposition chamber without using a carrier gas;
said method comprising the following operational steps in sequence:
A. reducing pressure into said at least one deposition chamber, through activation of said vacuum pump, until one pressure value comprised within a preset operational pressure interval is obtained, into said at least one deposition chamber;
B. sublimating said at least one precursor in said at least one source, until one gas of said at least one sublimated precursor is obtained;
C. if not yet in said working position, bringing said at least one substrate in said working position and said at least one substrate to one preset working temperature;
D. depositing said at least one gas of said at least one precursor thereby sublimated, said gas exiting said at least one source (5, 5') through said at least one delivery mouth (51, 51'), directly on said substrate without using a carrier gas; and
E. cooling said at least one source;
wherein
said preset operational pressure interval is between 0.1 x10³ mbar and 100x10-³ mbar, optionally between 1x10⁻² mbar and 5x10⁻² mbar, more optionally between 2x10⁻² mbar and 4x10⁻² mbar and
wherein said preset deposition distance is between 0.5 cm and 5 cm, optionally between 1 cm and 3 cm, more optionally comprised between 1.5 cm and 2.5 cm.

According to another aspect of the invention, said at least one delivery mouth can be configured to be selectively open-closed, and said step A can occur with said at least one delivery mouth closed and said step D can occur with said at least one delivery mouth open.

According to a further aspect of the invention, said step A can further comprise feeding said at least one gas, optionally including one or more gases selected among the group comprising nitrogen, argon, neon, helium and hydrogen, into said at least one deposition chamber, through said at least one inlet mouth.

According to another aspect of the invention, said at least one pressure value within said preset operational pressure interval, in said at least one deposition chamber, can be obtained at said step A by:
- adjusting one feeding flux of said at least one gas into said at least one deposition chamber, optionally keeping one suction speed of said at least one vacuum pump to the maximum; or
- through a constant feeding flux of said at least one gas into said at least one deposition chamber, and:
   ∘ an adjustment of one flow rate of at least one valve, optionally a throttle valve, through which said at least one deposition chamber is operatively connected with said at least one vacuum pump; and/or
   ∘ an adjustment of one suction speed of said at least one vacuum pump, wherein optionally said adjustment of said suction speed of said at least one vacuum pump can be carried out continuously or at preset time intervals, in response to a measured value of said pressure in said at least one deposition chamber.

According to another aspect of the invention, in said step B, said at least one source can be heated up to a source temperature comprised between 70°C and 800°C, optionally between 80°C and 700°C, more optionally comprised between 100°C and 600°C and/or said at least one deposition chamber can be heated up to a temperature comprised between 40°C and 120°C, optionally between 50°C and 100°C, more optionally between 60°C and 80°C.

According to a further aspect of the invention, in said step C said at least one substrate can be heated up to one working temperature comprised between 30°C and 300°C, optionally comprised between 50°C and 200°C, more optionally comprised between 60°C and 150°C.

According to an additional aspect of the invention, if in said step A said at least one substrate is in said working position, said method can comprise cooling said at least one substrate, during said steps A and B, down to a temperature lower than one temperature that is required in said step B to sublimate said at least one precursor in said at least one source.

According to another aspect of the invention, before said step D the pressure difference between said at least one source and said at least one deposition chamber can be equal to or greater than 1x10⁻² mbar.

According to a further aspect of the invention, before said step A, said method can comprise letting said at least one gas, optionally one ultra-pure gas, optionally nitrogen, or one noble gas as argon, neon or helium, flow through said at least one deposition chamber, from said at least one inlet mouth thereof to said at least one outlet mouth thereof.

It is also a specific object of the present invention one method of deposition, on at least one substrate, of at least one Perovskite layer, the method comprising the following operational steps in sequence:
F. arranging at least one deposition chamber, wherein:
   - in said at least one deposition chamber at least one inlet mouth and at least one outlet mouth are obtained, configured to be selectively opened-closed so as to allow the entrance-exit of at least one gas in-out of said at least one deposition chamber;
   - said at least one deposition chamber, at said at least one outlet mouth thereof, is operatively connected to one vacuum pump;
   - said at least one deposition chamber houses at least one source, said at least one source being configured to receive at least one precursor of said Perovskite without using a carrier gas and said at least one source having at least one delivery mouth, to let one gas of said at least one precursor of said Perovskite, when it is sublimated into said source, pass directly from said at least one source into said at least one deposition chamber without using a carrier gas; and
   - said at least one deposition chamber houses at least one supporting device for said at least one substrate, said supporting device being configured to support said at least one substrate between at least one working position, wherein said at least one substrate is aligned with said at least one delivery mouth of said at least one source, at a preset deposition distance therefrom, and one resting position, wherein it is spaced apart from said at least one delivery mouth of said at least one source, at a distance greater than said preset deposition distance; and wherein
      said substrate is supported in said at least one deposition chamber and said at least one precursor of said Perovskite is charged into said at least one source of said at least one deposition chamber without using a carrier gas;
G. depositing at least one layer of said at least one precursor of said Perovskite on said at least one substrate, through the method described above;
H. depositing at least one layer of another precursor of said Perovskite on said at least one substrate, through the method described above; and
I. if on said substrate, due to a chemical reaction between said at least one precursor and said at least another precursor of said Perovskite, the growth of said at least one layer of said Perovskite is obtained, interrupting the method; otherwise
J. going back to step H.

According to another aspect of the invention, if only one source is housed into said at least one deposition chamber, said method can comprise between said step G and said step H and/or, possibly, between each step H and the next one, the substitution of said source into said at least one deposition chamber containing said at least one precursor, with another source containing said at least one other precursor or the replacement, into said source, of said at least one precursor with said at least one other precursor; or if said at least one deposition chamber comprises two or more sources, said method can comprise loading said at least one precursor and said at least one other precursor in a respective source and moving said substrate between one source and the other, between said step G and said step H and/or, optionally, between each step H and the one next thereto; and if said method is carried out in two or more deposition chambers 2, said method can comprise between said step G and said step H and/or, optionally, between each step H and the next one, moving said substrate between one deposition and at least another deposition chamber.

According to a further aspect of the invention, said pressure value of said at least one deposition chamber, one pressure value of said at least one source said temperature value of said substrate and said deposition distance, within each step G and H, can be adjusted in advance or continuously or at preset intervals during execution of said method.

According to an additional aspect of the invention, after the execution of the last executed step H, said method can comprise feeding into said at least one deposition chamber at least one ultra-pure gas, optionally selected among the group comprising nitrogen or one noble gas comprised between argon, neon, or helium.

According to another aspect of the invention, said at least one precursor and said at least another precursor can be selected from the group comprising: PbI₂, MAI, FAI, Csl, SnI₂, PbCl₂, EuCl₃, EuI₂, in the form of powder or granules or tablets; and/or
wherein said substrate is made of one material selected from the group comprising glass, Silicon, PEN, PET, optionally provided with one surface layer of ITO or PTAA or FTO or TiO₂ or ZnO or said substrate is made of Aluminum or Titanium or Silicon Carbide.

Furthermore, it is a specific object of the present invention one apparatus for deposition, on at least one substrate, of at least one layer of at least one precursor of Perovskite or at least one layer of Perovskite, comprising:
- at least one vacuum pump;
- at least one deposition chamber operatively connected to said at least one vacuum pump, in said at least one deposition chamber at least one inlet mouth and at least one outlet mouth being obtained, each configured to be selectively opened-closed to allow the entrance-exit of at least one gas;
- at least one source, housed inside said at least one deposition chamber, said at least one source being configured to receive at least one precursor of said Perovskite without using a carrier gas and said at least one source having at least one delivery mouth, configured to let one gas of said at least one precursor of said Perovskite, when obtained into said source, pass from said at least one source into said at least one deposition chamber without using a carrier gas;
- at least one supporting device for said substrate, said supporting device being housed into said at least one deposition chamber and configured to support said substrate between at least one working position, wherein said at least one substrate is aligned with said at least one delivery mouth of said at least one source, at a preset deposition distance therefrom, and one resting position, wherein it is spaced apart from said at least one delivery mouth of said at least one source, at a distance greater than said preset deposition distance;
- at least one control device, configured to control the selective opening-closing of said at least one inlet mouth and at least one outlet mouth obtained into said at least one deposition chamber, the movement, through said supporting device, of said substrate between said working position and said resting position and between said at least one source and said at least another source, if provided in said at least one deposition chamber or between said at least one deposition chamber and said at least another deposition chamber, if provided in said apparatus, the activation of said vacuum pump, as well as to adjust one pressure value of said at least one deposition chamber, one pressure value of said at least one source, one temperature value of said substrate and said deposition distance, according to one of the method above recalled.

According to another aspect of the invention, said at least one source can comprise one face facing, in use, said substrate, wherein one plurality of delivery mouths is obtained, optionally four, each delivery mouth having one optionally rectangular or oval or circular plant configuration, optionally having a size different from that of other delivery mouths of the plurality of delivery mouths, if circular, having a diameter optionally comprised between 0.5 cm and 1.25 cm, based on the geometry of the deposition chamber and the number of sources comprised into said at least one deposition chamber, wherein the apparatus can optionally comprise at least one shutter for each source, said shutter being configured to selectively open-close only one or more delivery mouths at the time, in sequence or simultaneously, keeping the remaining closed.

The dependent claims refer to preferred and advantageous embodiments of the invention.

### BRIEF DESCRIPTION OF THE DRAWINGS

The present invention will be now described, for illustrative but not limiting purposes, according to its preferred embodiments, with particular reference to the drawings in the accompanying Figures, wherein:
Figures 1a and 1b respectively show the main steps of the method of the present invention, more particularly the steps of the method of the present invention for the deposition of at least one layer of at least one Perovskite precursor on at least one substrate and the steps of the method of the present invention for the deposition of at least one layer of Perovskite on such at least one substrate;
Figures 2a to 2c respectively illustrate one substrate during the successive implementation steps of the method of Figure 1b;
Figures 3a to 3c are schematic representations of the apparatuses and process variables involved in the deposition of a PSK layer on a substrate according to, the traditional HV-PVD method (Fig. 3a), the traditional CSS method (Fig. 3b) and the method of the present invention, respectively;
Figures 4a and 4b show another schematic representation of some components of the apparatus according to the present invention, in two successive execution steps of the method of the present invention;
Figure 4c is a block diagram of the deposition chamber and the main components of the apparatus of the present invention connected thereto;
Figures 5a to 5c respectively illustrate, a bottom view of the apparatus of the present invention, and two longitudinal section views, taken along section lines A-A and B-B, respectively, of Figure 5a; and
Figures 6a and 6b are graphs illustrating the results of some comparative tests carried out to determine the quality of a Perovskite layer deposited on a substrate with the method of the present invention, with respect to a traditional method.

### EMBODIMENTS OF THE INVENTION

Before entering into the merits of the invention, it is specified that in the present description and in the following claims, by the general term Perovskite (PSK), it is intended a mineral having both a composition of the ABX₃ type and a composition of the AxA'1-xByB'1-y(XzX'1-z)₃ type, wherein: A and B are cations, A can be both organic and inorganic, B is inorganic and X is the anion which is inorganic. One type of Perovskite involved in the present invention is, for example, described in the document referred to in bibliographic reference [1].

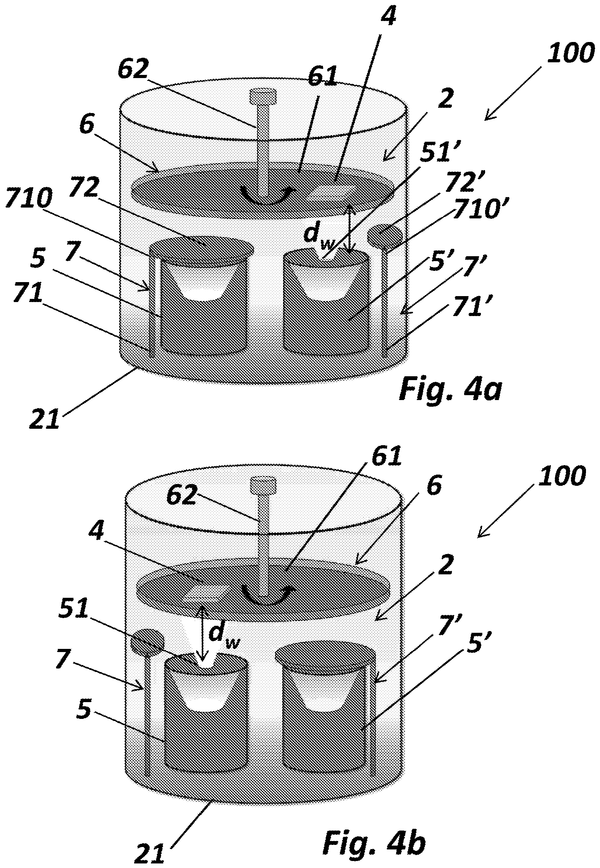

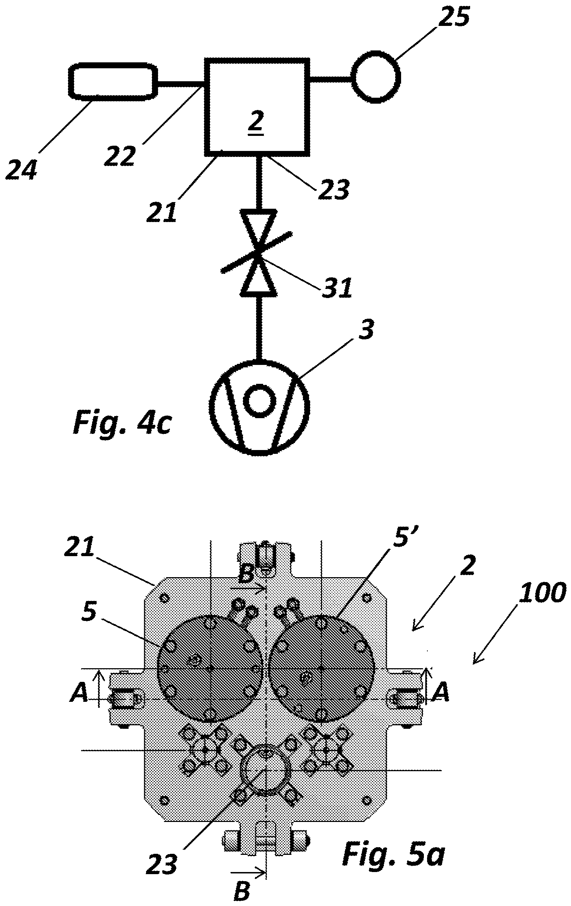

It is also specified that the method of the present invention is implemented by means of an apparatus (which forms part of the present invention and which will be described in detail below) which apparatus comprises at least one deposition chamber, represented in its main aspects in Figures 4a to 5c, which deposition chamber is indicated in the drawings with the reference number 2 and is operatively connected, in a way suitable in the field, to a vacuum pump 3 (see, in particular, Figure 4c). The vacuum pump 3, which is placed in fluid communication with the deposition chamber 2, optionally by means of one valve 31, optionally a throttle valve, is configured to reduce the pressure in the deposition chamber 2 within a preset operating interval ΔPc. The deposition chamber 2 is configured to internally support at least one substrate 4 on which the growth of at least one Perovskite layer is to be obtained. The at least one substrate 4 is optionally made of a material selected from glass, Silicon, PEN (polyethylene naphthalate) or PET (polyethylene terephthalate), optionally but advantageously provided with a surface layer of ITO (Indium-Tin oxide) or PTAA (Polytriarylamine) or FTO (Fluoro-Tin oxide) or other metal oxides (such as TiO₂, ZnO). The substrate 4 can also be made of Aluminum or Titanium or Silicon Carbide.

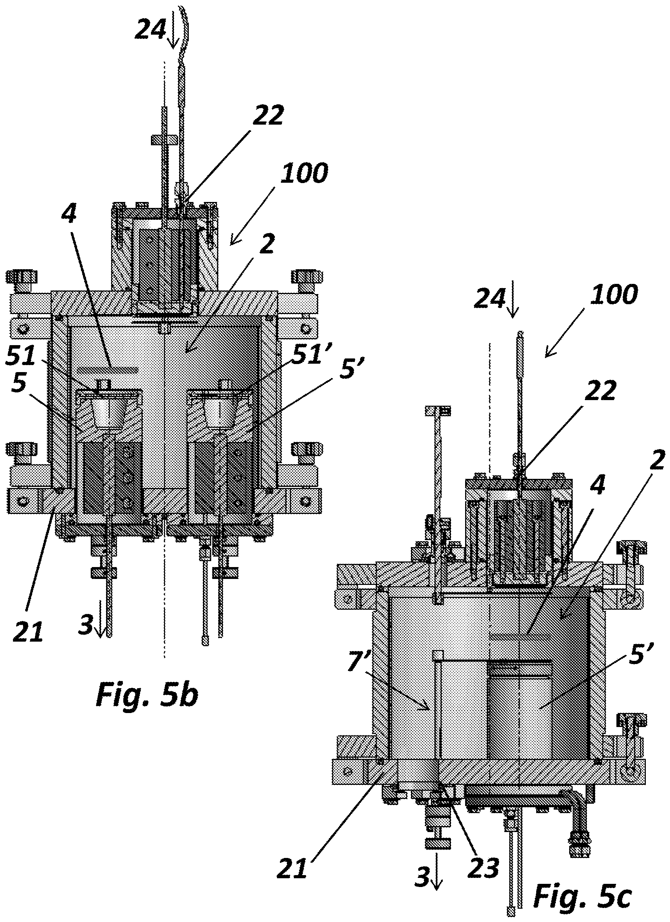

In the at least one deposition chamber 2, which is delimited at the bottom by a bottom wall 21, there is housed at least one source 5, for example directly or indirectly inserted into a respective through opening obtained in said bottom wall 21 (as shown in Figures 5b and 5c). Such a source 5 is configured to receive at least one precursor of the Perovskite which it is desired to be deposited on the at least one substrate 4, for example PbI₂ (Lead iodide) or MAI (Methylammonium iodide) or FAI (Formammidinium iodide), Csl ( Cesium iodide), SnI₂ (Tin iodide), PbCl₂ (Lead chloride), EuCl₃ (Europium chloride), EuI₂ (Europium iodide), in the form of powder, possibly also in the form of granules or tablets.

In the at least one source 5 there is at least one delivery mouth 51 (optionally configured to be selectively open and closed) configured to allow one gas of Perovskite precursor, when generated in a way known in the field into source 5, due to the effect of heating of the source itself, pass from the source 5 into the respective deposition chamber 2.

The at least one deposition chamber 2 is in communication with the outside through at least one inlet mouth 22 (only one represented in Figure 4c, 5b and 5c), optionally but advantageously obtained at the top thereof, the at least one mouth 22 inlet being configured to be placed in fluid communication with at least one source 24 of one gas. The at least one deposition chamber 2 is also in communication with the outside through at least one outlet mouth 23 (also shown in Figure 4c, 5a-5c), optionally but advantageously obtained at the bottom wall 21 thereof or in proximity thereto. The at least one inlet mouth 22 and the at least one outlet mouth 23 are configured to allow, respectively, the inlet and outlet of one gas, as will be seen better below, for example of the gas coming from source 24, in and from the at least one deposition chamber 2.

In the at least one deposition chamber 2, at least one supporting device 6 (see Figures 4a and 4b) is housed, the supporting device 6 being configured to support the at least one substrate 4 between at least one working position, wherein the at least one substrate 4 is aligned with at least one delivery mouth 51 of the at least one source 5, at a preset deposition distance d_{w} therefrom, and one resting position, wherein the at least one substrate 4 is spaced apart from the at least one delivery mouth 51 of the at least one source 5, optionally out of alignment with respect thereto, at a distance greater than the preset deposition distance d_{w}.

That said, the present invention comprises a method 1 for deposition of at least one layer of at least one Perovskite precursor on at least one substrate 4, when such at least one substrate 4 is supported in at least one deposition chamber 2 as described above, optionally in its own resting position, and when at least one precursor of such Perovskite is loaded into at least one source 5 of the at least one deposition chamber 2.

That method 1 comprises a first operational step A wherein, for example with the at least one delivery mouth 51 closed of the at least one source 5 (which is closed before the execution of step A, if it is open), the pressure in the at least one deposition chamber 2 is reduced, by activating the vacuum pump 3 and, if present, optionally by controlling valve 31, until a working pressure value P_{c} is reached within the interval of preset operating pressure ΔPc. More specifically, if a valve 31 is present, the pressure value P_{c} within the working interval ΔP_{c} can be reached in the deposition chamber 2 by activating the vacuum pump 3, until a value limit working pressure value P_{b} is reached, which value is lower than or equal to pressure P_{c} and therefore by controlling the valve 31, by increasing, if necessary, the pressure in deposition chamber 2 from the P_{b} value to the P_{c} value.

Method 1 therefore comprises one subsequent step B wherein the precursor is sublimated in the at least one source 5, until a gas of that precursor is obtained, and one step C, wherein, if not already in the working position, the at least one substrate 4 is placed in axis with the at least one delivery mouth 51 of the at least one source 5, at the preset deposition distance d_{w} (i.e. in its working position) and the at least one substrate is brought to a working temperature T_{w} which will be indicated below.

According to one variant of the method of the present invention, if the at least one substrate 4 on which it is desired to deposit at least one layer of at least one Perovskite precursor is already in its working position, method 1 of the present invention would provide for cooling/heating such at least one substrate 4, at a working temperature depending on the type of precursor to be deposited (always lower than the temperature of the precursor source) optionally between -40°C and 300°C, by means of a suitable cooling system, during steps A and B, to control the heating of the at least one substrate 4 during the sublimation of the precursor (step B) and to prevent any contamination, due to the imperfect sealing of the at least one source 5 in the deposition chamber 2. During step C, according to this variant of method 1, therefore, the substrate 4 would then be heated or cooled to a working temperature T_{w} which will be indicated below.

Therefore method 1 of the present invention comprises one step D wherein the release of the gas of the precursor thus sublimated occurs, from the at least one source 5, which gas is diffused through the respective delivery mouth 51, directly (i.e. without passing through other chambers or elements of the system) towards the at least one substrate 4 and is deposited thereon at a deposition rate which varies based on the precursor, according to the pressure P_{c} of the deposition chamber 2, the temperature of the substrate 4, and the distance d_{w} of the substrate 4 from the respective delivery mouth 51. If the at least one delivery mouth 51 is optionally configured to be selectively open-closed, and is closed in the previous steps of the method, at step D it opens allowing the gas to escape.

Method 1 then comprises one step E wherein, once the precursor deposition step D is ended, the source 5 is cooled, for example by waiting for a certain time or actively, through a suitable cooling system (not shown in the Figures) and the at least one substrate 4 with the Perovskite precursor layer deposited thereon, can be moved to the resting position.

According to a particularly advantageous aspect of the invention, in method 1 of the present invention the preset operational pressure interval ΔP_{c} is comprised between 0.1 ×10⁻³ mbar and 100x10-³ mbar, optionally between 1x10⁻² mbar and 5x10⁻² mbar, more optionally between 2x10⁻² mbar and 4x10⁻² mbar and the preset deposition distance d_{w} is between 0.5 cm and 5 cm, optionally between 1 cm and 3 cm, more optionally between 1.5 cm and 2.5 cm.

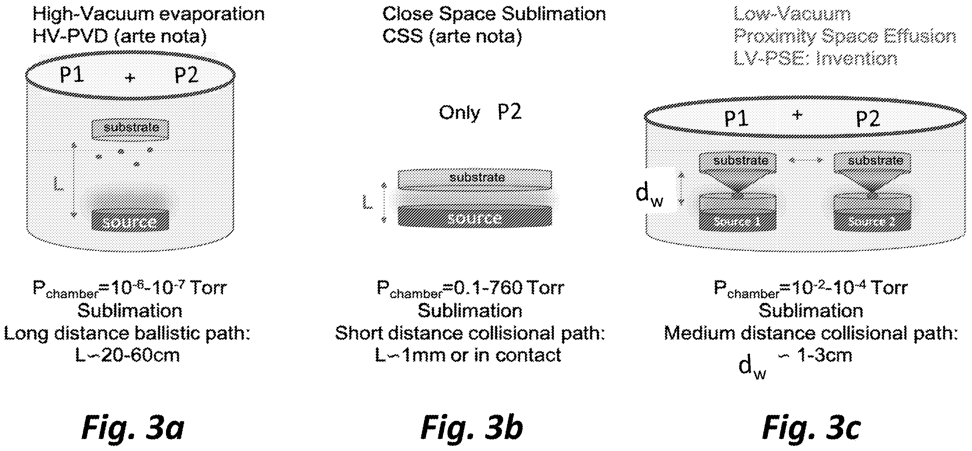

As can be seen (see for example Figures 3a to 3c), both the pressure P_{c} in the at least one deposition chamber 2 and the deposition distance d_{w} of method 1 of the present invention are intermediate with respect to the two traditional deposition methods HV -PVD and CSS and this, as will be noted below, brings enormous benefits.

According to an advantageous aspect of the invention, before step A of method 1, one preliminary step (A₀) can be provided wherein, between the at least one inlet mouth 22 and the at least one outlet mouth 23, at least one gas it is delivered into the at least one deposition chamber 2, optionally an ultrapure gas, selected from nitrogen or a noble gas such as argon, neon or helium. This intermediate step advantageously allows eliminating any moisture present inside the at least one deposition chamber 2 as well as any contaminants before the activation of the vacuum pump 3 and, if provided, the valve 31 control.

According to one variant of the method of the present invention, during step A, for example, if provided after reaching the limit pressure P_{b}, method 1 can optionally comprise introducing into the at least one deposition chamber 2, again through the aforementioned inlet mouth 22 at least one gas, optionally one or more chosen from nitrogen or another noble gas such as argon, neon, helium, also in combination with hydrogen or mixtures of these, supplied by the gas source 24 (shown in Figure 4c), suitably connected upstream of the at least one deposition chamber 2. The implementation of step A includes, as already mentioned above, the activation of the vacuum pump 3 and, if present, optionally the control of valve 31, until a working pressure value P_{c} in the at least one deposition chamber 2, comprised within the preset operational pressure interval ΔP_{c} is reached, before the start of step B.

The introduction of one gas into at least one deposition chamber 2, such as nitrogen, can be advantageous [30] to improve the characteristics of the precursor layer to be deposited on substrate 4, also by chemical reaction therewith.

In this regard, it is noted that according to a particularly advantageous aspect of the present invention, a pressure value P_{c} within the preset pressure interval ΔP_{c}, inside the at least one deposition chamber 2, can be obtained at step A:
- if method 1 of the present invention is carried out without introducing a noble gas or nitrogen also in combination with hydrogen or mixtures thereof, into the at least one deposition chamber 2, depending on the maximum vacuum of the vacuum pump 3 connected to the same at least one deposition chamber 2; or
- if method 1 of the present invention is performed with the introduction of one gas into at least one deposition chamber 2:
   - by adjusting the delivery flow of the noble gas or nitrogen also in combination with hydrogen or mixtures thereof, within the at least one deposition chamber 2, by means of one valve, optionally a throttle valve (not shown in the drawings), located upstream of the at least one deposition chamber 2 between the gas source 24 and the deposition chamber 2 itself, optionally by keeping the suction speed of the vacuum pump 3 at maximum; or
   - through the delivery of the noble gas or nitrogen also in combination with hydrogen or mixtures thereof, inside the at least one deposition chamber 2, at constant flow, and adjustment of the flow rate of valve 31 and/or adjustment of the suction speed of the vacuum pump 3 (figure 4c).

That adjustment of the pressure P_{c} in the at least one deposition chamber 2 can occur by adjusting continuously or at predetermined intervals the opening-closing (or the flow rate) of the valve 31, in response to a pressure P_{c} value inside the at least one deposition chamber 2, for example measured through a Pirani vacuum gauge (represented in Figure 4c with reference 25) or another suitable device.

According to the method of the present invention, at step B the at least one source 5 is brought to a source temperature Tₛ between 70°C and 800°C, optionally between 80°C and 700°C, more optionally between 100°C and 600°C, which allows a good sublimation rate of the precursor contained therein and which regulates the corresponding internal pressure of source 5, without altering its state (for example, the source temperature Tₛ must be such that is does not cause melting of the precursor). Purely by way of non-limiting example, if the precursor loaded in the source is PbI₂, the source temperature Tₛ is between 250°C and 400°C, optionally between 300°C and 370°C, more optionally between 320°C and 350°C.

Still according to the method of the present invention, at step B the at least one deposition chamber 2 is advantageously heated, in a way known in the field, to a temperature between 40°C and 120°C, optionally between 50°C and 100°C, more optionally between 60°C and 80°C.

According to another advantageous aspect of the invention, at the end of step C i.e., before starting the actual deposition of the precursor on the at least one substrate 4, the at least one substrate 4 is brought to a working temperature T_{w} between 30°C and 300°C, optionally between 50°C and 200°C, more optionally between 60°C and 150°C. The temperature at which the at least one substrate 4 is brought depends on the precursor that is to be deposited thereon. Purely by way of non-limiting example, it is of note that, if the precursor loaded in the source is PbI₂, the working temperature T_{w} is between 90°C and 150°C, optionally between 110°C and 140°C, more optionally between 120°C and 130°C.

In method 1 of the present invention, before step D, the pressure difference ΔP_{sc} between the internal environment of the at least one source 5 and the at least one deposition chamber 2 is equal to or greater than 1x10⁻² mbar. As will also be seen below, with this pressure difference and the working conditions described above it is possible to effectively control the deposition process of the precursor on the at least one substrate 4.

The method 1 described above for the deposition of at least one layer of at least one PSK precursor on at least one substrate 4 is advantageously used in a method 10 of deposition of at least one layer of Perovskite on at least one substrate 4, which is the object of the present invention and is implemented in the manner described below.

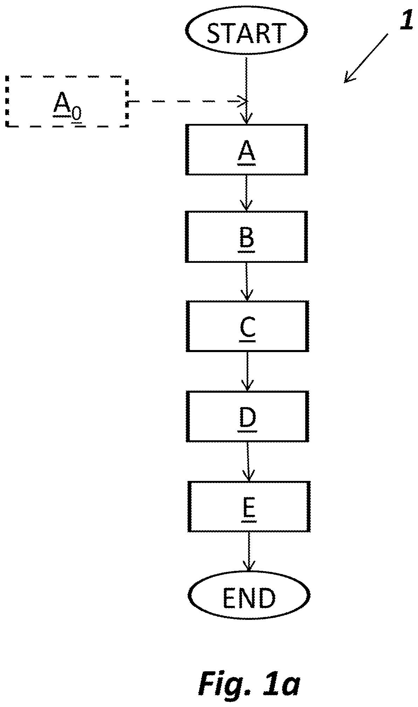

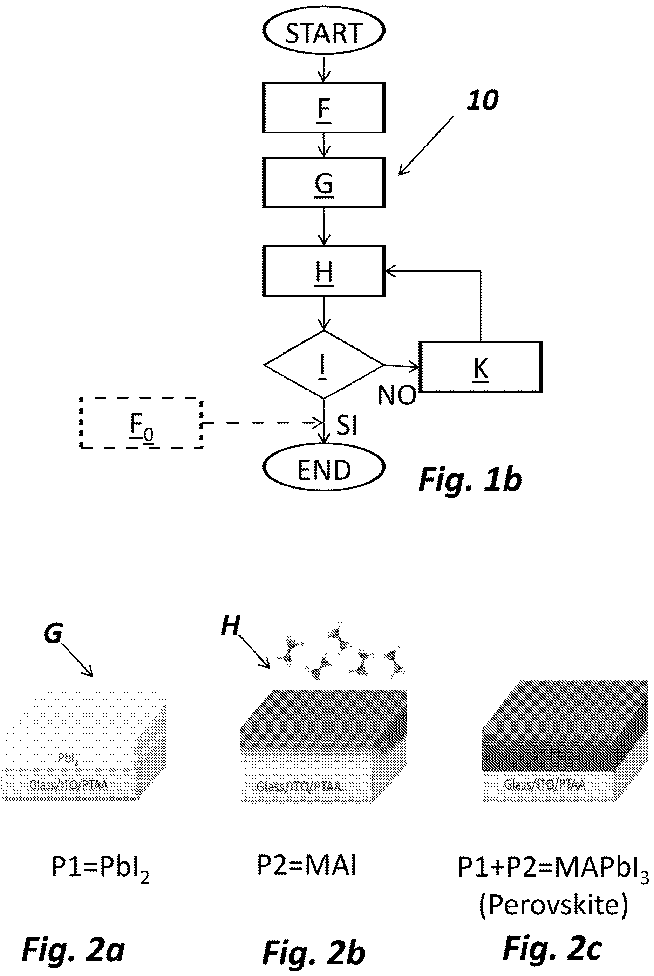

In order to obtain the growth of a PSK layer on at least one substrate 4 (see in particular Figure 1b), method 10 comprises the following operational steps in sequence:
F. arranging at least one deposition chamber 2 of the type described above, wherein the at least one substrate 4 is supported, optionally in a resting position, and wherein at least one precursor of the Perovskite is loaded into the at least one source (5, 5') of the at least one deposition chamber 2;
G. depositing at least one layer of the at least one precursor (PbI₂) of said Perovskite on the at least one substrate 4, through method 1 described above;
H. depositing at least one layer of the at least another precursor (MAI) of that Perovskite on the at least one substrate 4, through method 1 described above; and
I. if on the at least one substrate 4, due to a chemical reaction between the at least one precursor (PbI₂) and the at least another precursor (MAI), the growth of that at least one layer of Perovskite is obtained, interrupting the method; otherwise
J. repeating step H with at least another precursor.

Method 10 of the present invention provides, in other words, depending on the type of PSK to be grown on the at least one substrate 4 and according to the number of precursors with which that PSK can be obtained, two or more deposition steps of its precursors, according to the methods described above, in the same deposition chamber 2 or in several deposition chambers 2 connected with each other, so that the at least one substrate 4, passing from one deposition chamber to the other, can optionally remain in a vacuum condition, for example under pressure conditions similar to those obtained in the deposition chambers 2 between which it is moved.

If method 10 of the present invention is carried out in a single deposition chamber 2 comprising a single source 5 (case not represented in the drawings), this implies that method 10, between step G and step H and/or optionally between each step H and the next one, comprises the replacement into deposition chamber 2 of the source 5 containing the at least one precursor (for example, PbI₂) with another source 5' containing the at least another precursor (for example for example, MAI) or the replacement, into source 5, of the at least one precursor (for example, PbI₂) with the at least another precursor (for example, MAI).

If, on the other hand, method 10 of the present invention is carried out in a single deposition chamber 2 comprising two or more sources, method 10 of the present invention comprises loading the respective precursor into each respective sources (5, 5 ') and moving substrate 4 between one source (for example 5 in Figures 4a to 5c) and the other (for example 5' in Figures 4a to 5c), between step G and step H and/or, possibly, between each step H and the following one, for example if the sources 5 were more than two.

Again, in the case (not shown in the drawings) wherein method 10 of the present invention is carried out in a plurality of deposition chambers 2 connected to each other in the described above suitable way, wherein each deposition chamber 2 comprises a single source 5 or more sources (5, 5 '), method 10, depending on the configuration of the system, between step G and step H and/or, possibly between each step H and the following one, may comprise:
- the replacement of source 5 in one deposition chamber 2 containing at least one precursor with another source 5' containing the at least another precursor or the replacement, in that source 5, of the at least one precursor with the at least another precursor; and/or
- the displacement of the at least one substrate 4 between one source 5 and the other 5', even several times, in the same deposition chamber 2 or between one deposition chamber and the other.

At the end of the step H last performed by the method, before stopping method 10 and removing the substrate 4 from the at least one deposition chamber 2, the present invention optionally comprises a further step F₀, wherein the at least one deposition chamber 2 is filled with an ultrapure gas, optionally nitrogen or a noble gas such as argon, neon or helium, both to allow the venting of the at least one deposition chamber 2 and protecting the at least one substrate 4 on which the PSK layer has been deposited from contamination.

According to a particularly advantageous aspect of the invention, in method 1 and therefore in method 10, the pressure P_{c} in the at least one deposition chamber 2, the pressure value Pₛ in each source 5, the substrate temperature value Tₛ and the deposition distance d_{w}, in steps A to F, are adjustable in advance and the selective opening-closing of the at least one inlet mouth 22 and outlet mouth 23 obtained in the at least one deposition chamber 2, the selective opening-closing of the at least one delivery mouth (51, 51'), the displacement, by means of supporting device 6, of the at least one substrate 4 between its working position and its resting position and between one source 5 and the other 5', if present in at least one deposition chamber 2, or between one deposition chamber 2 and the other, when present, and the activation of the vacuum pump 3 as well as the opening-closing of valve 31 (for adjusting its power) are configured to be adjusted, for example by an operator, for example manually or by means of a suitable control device (not shown in the Figures) wherein an application for manual or automatic control of the aforementioned operating parameters of the apparatus and activation deactivation of its components is installed.

In the following, by way of non-limiting example, an example of application of the present invention is provided, to obtain the growth of PSK, specifically of MAPbI₃, on a glass substrate.

In accordance with method 10 of the present invention, respective powders of precursors (PbI₂, MAI), in quantity between 2g and 8g, are loaded at step F in two sources 5 and 5' of a deposition chamber 2, the sources configured to be selectively open-closed. The average consumption for deposition of a single precursor is advantageously between 2 mg and 5 mg, depending on the size of the substrate 4, therefore it is quite clear that the sources (5, 5'), once loaded, can be used several times in the method of the present invention before it is necessary to proceed with a new refill (the average consumption of precursor can be estimated at about 2g/year). In this way, it appears quite evident how method 10 of the present invention is advantageous with respect to the traditional HV-PVD and CSS methods which, having higher precursor consumptions, for example in the order of 2g/month, for deposition on substrates 4 of equal size, require more frequent refilling and maintenance activities. At step F also substrate 4 is placed on the supporting device 6 in its resting position.

According to method 10 of the present invention, at step G, before starting the sublimation of the first precursor (corresponding to step A of method 1), the deposition chamber 2 is crossed by an ultrapure nitrogen flow (step A₀), to eliminate any humidity present in the deposition chamber 2 and any contaminants present therein.

At this point, the deposition chamber 2 is filled with nitrogen and, thanks to the activation of the vacuum pump 3 and, if present optionally through control of valve 31, the pressure P_{c} in the deposition chamber is brought within the preset interval ΔP_{c} of 2-5x10⁻² mbar, which can advantageously be monitored, in a suitable way, by means of the aforementioned Pirani vacuum gauge 25 which operates in the interval between 10 mbar and 10⁻³ mbar. Then, the precursor (PbI₂) in the first source 5 is sublimated by heating the source 5 itself, in a known way. By way of example, for a precursor of the BX₂ type such as PbI₂, the temperature of the source is equal to 350°C, in any case between 300°C and 380°C depending on the pre-established process conditions. At this point the pressure difference ΔP_{sc} between the interior of the source 5 and the deposition chamber 2 is approximately 1x10⁻² mbar and this makes it possible to control the properties of the precursor gas (its kinetics, energy, etc.) as desired. During the heating of the first source 5, the deposition chamber 2 is heated to a temperature T_{w} lower than 100°C (as described above) and is kept at that temperature until the end of the PSK deposition process.

As soon as the source 5 has reached the required working temperature (it takes about 50 minutes), the substrate 4 is brought into the working position aligned with its delivery mouth 51, at a distance d_{w} between 0.5cm-5cm and the delivery mouth 51 is opened. At that point the precursor gas is free to leave the source and is deposited on the substrate, in a time interval which varies according to the thickness of the precursor to be deposited on the substrate 4. By way of example, a deposition rate of PbI₂ with the substrate at a source 5 temperature Tₛ equal to 350°C and at a pressure in the deposition chamber 2 equal to of 4x10⁻² mbar is approximately 3 nm/min. During the deposition, the substrate is kept at a temperature of about 120°C. At this point, once the deposition is complete, the substrate 4 is brought into the resting position, for a time interval necessary for the first source 5 to cool. That time interval can be reduced, for example, by actively cooling source 5, in a known way, by means of a suitable cooling system (not shown in the Figures).

Then, according to step H of method 10 of the present invention, a second source 5' is heated to a temperature required for the sublimation of the other precursor of the AX type. By way of example, for a precursor of the AX type such as MAI, the temperature of the source is equal to 135°C, in any case between 100°C and 150°C depending on the pre-established process conditions. As soon as the source 5' has reached the required working temperature (it takes about 15 minutes), the substrate 4 is brought into the working position aligned with its delivery mouth 51', at a distance d_{w} between 0.5 cm and 5cm and the delivery mouth 51 is opened. At that point the precursor gas is free to leave the source and is deposited on the substrate, in a time interval which varies according to the desired thickness of the precursor that is to be deposited on the substrate. By way of example, a deposition rate of MAI with the PbI₂ at a source 5' temperature Tₛ equal to 135°C and at a pressure in the deposition chamber 2 equal to of 4x10⁻² mbar is approximately 2.5 nm/min. During the deposition, the substrate is kept at a temperature of about 75°C. At this point, once the deposition is complete, the substrate 4 is brought into resting position, for a time interval necessary for the source 5' to cool. That time interval can be reduced, for example, by actively cooling source 5', through the suitable cooling system above.

Since in the case of MAPbI₃ deposition, in the method of the present invention the growth of the PSK layer occurs in two steps, at step I method 10 ends. If, on the other hand, the PSK to be deposited on the substrate was of the type AₓA'₁₋ₓB_{y}B'_{1-y}(X_{z}X'_{1-z})₃, for example if it was a mixed Perovskite having the following formula CsₓMA₁₋ₓPb_{y}Sn_{1-y}(I_{z}Br_{1-z})₃, method 10 would comprise, for example, the execution of as many deposition steps as the precursors to be deposited are, and therefore we would have:
- a first step G, wherein the precursor of type BX₂ is deposited;
- a second step H, wherein the precursor of type B'X'₂ is deposited;
- a third step H', wherein the precursor of type AX is deposited; and
- a fourth step H', wherein the precursor of type A'X' is deposited.

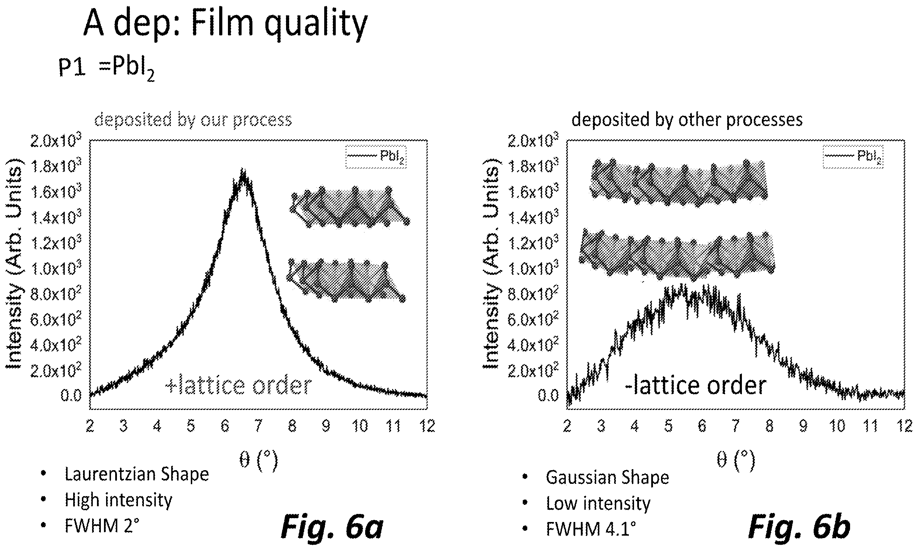

In order to demonstrate the effectiveness of method 10 of the present invention, the results of performed comparative tests are reported, wherein one layer of PSK was deposited on a substrate 4 with the method of the present invention (Figure 6a) and with the traditional HV method -PVD (Figure 6b). In particular, Figures 6a and 6b illustrate the high quality of the PSK layer deposited on the substrate 4, in terms of structural characteristics through implementation of the method of the present invention, the main process conditions of which are detailed below:
- temperature of the first precursor PbI₂ (i.e., of the first source 5) equal to 350°C,
- temperature of the second precursor MAI (i.e., of the first source 5') equal to 135°C,
- pressure in the deposition chamber 2 P_{c} equal to 4x10⁻² mbar,
- wherein, during the deposition of PbI₂ the substrate was kept at 120°C, and during the deposition of MAI, the substrate was kept at 75°C,
- deposition distance d_{w} between source and substrate equal to 2cm,
- deposition time interval of PbI₂=30min,
- deposition time interval of MAI=60min,
- thickness of the MAPbI₃ layer obtained, equal to 180nm.

In Figures 6a and 6b the quality of the deposited PbI₂ layer is evaluated on the basis of the distribution curve of the growth axis of the reticular planes (rocking curve) obtained from an X-ray analysis performed on the substrate with PSK. The shape of that distribution curve and its width at half height (Full Width at Half Maximum - FWHM) show how the material deposited on the substrate according to the method of the present invention is an ordered material with a high quality of the atomic reticular order (The "lattice order" in Figure 6a is evidently higher than that of Figure 6b), just like in an ideal material, that is, a material well-ordered at the atomic level and with a low number of lattice imperfections.

That said, the method described above can be advantageously implemented by means of an apparatus, indicated in the Figures with the reference number 100, for the deposition on a substrate 4 of at least one layer of at least one precursor of a PSK or of at least that PSK, which also forms the object of the present invention and includes:
- at least one vacuum pump 3;
- at least one deposition chamber 2 operatively connected to the at least one vacuum pump 3, optionally through a valve 31, optionally at least one throttle valve, in the at least one deposition chamber 2 at least one inlet mouth 22 and at least one outlet mouth 23 being obtained, each configured to be selectively opened-closed to allow the entrance-exit of at least one gas, as above described;

- at least one source (5, 5'), housed inside the at least one deposition chamber 2, the source (5, 5') being configured to receive at least one precursor of the Perovskite and at least one delivery mouth (51, 51'), optionally configured to be selectively opened-closed, configured to let one gas of the at least one precursor of said Perovskite, when obtained into the source (5, 5'), pass from the at least one source (5, 5') into the at least one deposition chamber (2);
- at least one supporting device 6 for the substrate 4, the supporting device being housed into the at least one deposition chamber 2 and configured to support that substrate 4 between at least one working position, wherein it is aligned with at least one delivery mouth (51, 51') of a respective source (5, 5'), at a preset deposition distance d_{w} therefrom, and one resting position, wherein it is spaced apart from the at least one delivery mouth (51, 51') of the source (5, 5'), optionally not aligned therewith, at a distance greater than the preset deposition distance d_{w}:
- at least one control device (not shown in the drawings), configured to control the selective opening-closing of the at least one inlet mouth 22 and at least one outlet mouth 23 obtained in the at least one deposition chamber 2, the optional selective opening-closing of the at least one delivery mouth (51, 51 '), the displacement, through the supporting device 6, of the substrate 4 between its working position and its resting position and between one source 5 and the other 5', if present in the at least one deposition chamber 2, or between one deposition chamber 2 and the other, when present, and the activation of the vacuum pump 3, the opening-closing of the valve 31 if present, as well as for imposing a pressure value P_{c} in the at least one deposition chamber 2, one pressure value P_{c} in the at least one source (5, 5'), a temperature value T_{w} of the substrate 4 and the preset deposition distance d_{w} .

The apparatus 100 of the present invention can also comprise:
- at least one gas source 24, as described above, connected upstream of the at least one deposition chamber 2 and in fluid communication therewith through the at least one inlet mouth 22; and
- at least one valve 31, between at least an outlet mouth 23 of the at least one deposition chamber 2 and the vacuum pump 3, in fluid communication therewith.

With such a configuration, the apparatus 100 according to the present invention can obtain, by means of the aforementioned control device, a pressure value P_{c} inside the at least one deposition chamber 2, in the preset pressure interval ΔP_{c}:
- as a function of the maximum vacuum of the vacuum pump 3, connected to the deposition chamber 2; or
- If present, by adjusting the delivery flow of the noble gas or nitrogen also in combination with hydrogen or mixtures thereof, within the deposition chamber 2, by means of one valve, optionally a throttle valve, located upstream of the deposition chamber 2 between the gas source 24 and the deposition chamber 2 itself, optionally by keeping the suction speed of the vacuum pump 3 at maximum; or
- if present, by introducing the gas into the deposition chamber 2 at constant flow and adjusting the suction speed of the vacuum pump 3 and/or adjusting the flow rate of the valve 31.

The adjustment of the pressure P_{c} inside the at least one deposition chamber 2 carried out by the control device can take place continuously or at predetermined intervals, for example in response to a value of the pressure P_{c} inside the at least one deposition chamber 2, for example measured by a Pirani vacuum gauge 25 Pirani vacuum or other device suitable for the purpose.

According to a preferred embodiment of the apparatus 100 of the present invention, each deposition chamber 2 is inferiorly delimited by a bottom wall 21 which supports two sources (5, 5'). The supporting device 6 housed in the respective deposition chamber 2 (shown only in Figures 4a and 4b) advantageously comprises one tray 61, rigidly fixed to a rod 62, optionally at the center thereof, which rod 62 is movably connected to a wall delimiting the deposition chamber 2 from above, optionally rotatable around its own longitudinal axis. In tray 61 there is at least one housing seat configured for housing the substrate 4. The movement of rod 62 and therefore of tray 61 rigidly fixed thereto causes the displacement of the substrate 4 housed in the housing seat, between the aforementioned resting position and an aforementioned working position. The housing seat is delimited by a through opening that exposes an area of the substrate 4 towards the source or sources (5, 5') installed in the deposition chamber 2. According to one variant of the present invention, in tray 61 of the present invention several housing seats can be obtained, of variable shape and size, for example of a square shape ranging from 1.5 cm × 1.5 cm up to 15 cm × 15 cm, which therefore allow implementing the method of the present invention with substrates 4 also having each time different dimensions, slightly larger than the respective housing seats, or allow implementing the method of the present invention on several substrates at the same time, depending on the number and configuration of the sources installed into deposition chamber 2. In any case, the person skilled in the art will have no difficulty in understanding how other shapes of the supporting device 6 are possible and fall within the scope of the present invention, as long as they allow the support 4 to be moved between its working position and its resting position, between one source and the other and, if provided, between one deposition chamber 2 and another.

According to an advantageous aspect of the invention, the supporting device 6 in each deposition chamber 2 can be heated-cooled, by means of a suitable heating-cooling system not shown in the drawings, in order to heat-cool the at least one substrate 4 housed thereon, which must be kept within the temperature range reported above during the implementation of the method of the invention. The heating-cooling system of the supporting device 6 allows implementing a thermal type shielding and prevents the heating of a source in the deposition chamber 2 from affecting the temperature of the substrate 4, when not required by the method of the invention.

The supporting device 6 is made of a material which is configured to thermally conduct well and at the same time resist corrosion. According to a preferred embodiment, given by way of non-limiting example, the supporting device 6 can be made of aluminum or copper and can be coated on the surface with an oxide layer.

Advantageously, the apparatus 100 of the present invention can further comprise at least one shutter (7, 7') for each source (5, 5'), which shutter (7, 7') is configured to selectively open one or more delivery mouths (51, 51'), for each source (5, 5'), in sequence or simultaneously, according to requirements, keeping the remaining ones closed. In this way, depending on the mutual position assumed between the substrate 4 in the working position and the delivery mouth(s) (51, 51 ') of the source (5, 5'), it is possible, by controlling the shutter ( 7, 7'), obtain the opening of one or more delivery mouth (51, 51') and thus control the deposition of the precursor on a more or less wide area of one face of the substrate 4 which, in use, is aligned with the respective source (5, 5'). Thanks to the use of the shutter (7, 7'), the mechanical shielding of one source (5, 5') from the others (5', 5) is also obtained, and cross-contamination between the precursors contained in them is avoided, and in addition, the reliability of the method is increased.

It should also be noted that a source can be thermally shielded from the others by also actively regulating its temperature Tₛ by means of a suitable cooling system. In this way, the sublimation of the precursor contained therein and therefore cross-contamination with the precursor or precursors of the other source or sources is prevented.

The shutter (7, 7') of each source, as can be seen from the figures, comprises at least one rod (71, 71') optionally extending from the bottom wall 21 delimiting the deposition chamber from below, which rod (71, 71') is configured to rotate around a pivot axis coincident with its own longitudinal axis and has a free end (710, 710') substantially at the same level of the face of the source (5, 5') wherein the delivery mouth(s) is(are) formed (51, 51'). The shutter (7, 7') further comprises one plate-like element 72 rigidly connected to this free end (710, 710') and configured to be rotated around the pivot axis coincident with the longitudinal axis of the rod 71, whereby it can be moved between a first position, wherein it closes all the delivery outlets (51, 51') obtained in the respective source (5, 5') and respective second working positions wherein only one or more of them is left open. In any case, the person skilled in the art will have no difficulty in understanding how other shapes of the shutter (7, 7') of each source can be implemented and fall within the protection scope of the present invention, provided that they allow selectively opening-closing one or more delivery mouths (51, 51') of each source (5, 5').

As an alternative to the shutter (7, 7') for each source, the apparatus 100 of the present invention can be configured to control the escape of the Perovskite precursor gas to be deposited, from the respective source (5, 5') wherein it is contained, with time intervals comparable to those of the shutter (7, 7') movement, by adjusting the pressure P_{c} inside deposition chamber 2. In fact, if this is high with respect to the pressure Pₛ inside the source (higher than a certain threshold value which depends on the precursor), the precursor gas will not be able to reach the substrate 4 and, therefore, to be deposited thereon. On the contrary, if the pressure P_{c} inside the deposition chamber 2 were reduced (below a threshold value that depends on the precursor), the precursor gas would be able to reach the substrate 4 and therefore to be deposited thereon. By adjusting the pressure P_{c} in the deposition chamber 2, it is therefore possible to implement the same opening and closing effect of delivery mouth(s) (51, 51') obtained through the shutter (7, 7').

In view of the above it is quite evident that the method and the apparatus according to the invention, overcomes the drawbacks described in the introduction. In fact, the deposition methods and the apparatus described above allow working in "non-high" vacuum conditions, contrary to traditional systems, and arranging the substrate 4 at an intermediate distance with respect to what has been allowed up to now by the same traditional methods (see in particular Figures 3a and 3b) with enormous advantages both in terms of cost of the equipment and in terms of waste and dispersion of the precursors used in each deposition chamber 2 and in terms of the necessary consequent cleaning and maintenance operations.

Not only that, the methods of the present invention allow regulating a greater number of process parameters (pressure of the deposition chamber 2, pressure of each source, temperature value of the substrate and distance of deposition) compared to traditional methods - as indicated in Figures 3a and 3b - and this allows precisely adjusting the thickness (which can even be half or 1/3 of the thickness obtainable with traditional methods) and the quality of the material deposited on the substrate 4.

One further advantage is represented by the easy and rapid transfer of the precursor onto a corresponding substrate 4, and the possibility, by suitably configuring the apparatus 100 with the desired number of deposition chambers (possibly connected to each other so as to maintain the vacuum in the passage of this substrate 4 between one chamber and the other) and sources (5, 5') to sequentially apply several layers of the same precursor or of different precursors on the same substrate 4, without the need to open and close the deposition chamber 2, or on more substrates at the same time, according to the various needs. By way of example, thanks to the method and apparatus of the present invention it is possible to deposit at least one layer of Perovskite on at least one substrate 4, by means of a method 10:
- comprising n-sequential deposition steps, wherein one layer of a precursor is deposited in each step (see the 2-step sequential method described above for the deposition of MAPbI₃ =PbI₂+MAI); or
- comprising the sequential deposition of alternating atomic layers of Perovskite precursors, in a multistep process (called layer by layer) wherein one substrate 4 is brought alternately between one source and the other for deposition, at each source, of an atomic layer of the respective precursor.

As far as the quality of the deposited PSK layer is concerned, as can be seen from the results presented in Figures 6a and 6b, the quality of the PSK layers obtained thanks to the present invention allows scaling down the thickness of the deposited PSK layer and the quantity of material used with the double benefit of being able to obtain semi-transparent layers of PSK which can therefore be easily used in the required fields (as mentioned in the solar cell field) and cost reduction.

Furthermore, the method of the present invention and the apparatus for its implementation allow for the required scalability. In fact, the substrate 4 to which the method of the present invention can be applied can have dimensions ranging for example from 1.5 cm × 1.5 cm up to over 15 cm × 15 cm. This makes the method of the present invention more interesting from the point of view of its large-scale industrial application. In fact, the method of the present invention can be advantageously implemented to coat substrates for making Perovskite solar cells.

In the foregoing the preferred embodiments were described, and some modifications of the present invention were suggested, but it should be understood that those skilled in the art can make modifications and changes without departing from the relative scope of protection, as defined by the appended claims.

Thus, for example, the delivery mouths (51, 51') can be four in number for each source (5, 5'), obtained in a plug element which closes each source (5, 5') at the top and, if circular in shape, they can have a different diameter, depending on the geometry of the deposition chamber 2, the trajectory that the precursor gas must travel to reach the substrate 4, the trajectory followed by the substrate 4 to pass between its resting position and its working position and its size.

As already mentioned above, with methods 1 and 10 and the apparatus 100 of the present invention, the number of sources (5, 5') in each deposition chamber 2 can be adapted to the need, by composition and number of cations (A, B) and anions (X). Furthermore, it is possible to define by means of the control device of the apparatus 100 of the invention the residence time of the substrate at each source (5, 5') and it is possible to set a sequence of *ad hoc* deposition repetitions, to obtain the layer-by-layer deposition of different PSK precursors, so as to allow the growth of PSK layered structures of different compositions.

Furthermore, the apparatus 100, in its simplest configuration, comprises at least one deposition chamber 2 and at least one vacuum pump 3 connected thereto. According to a more complex configuration, the apparatus 100 comprises, in addition to the at least one deposition chamber 2 and the at least one vacuum pump 3 connected thereto, also one source 24 of gas, connected upstream of the at least one deposition chamber 2, and in fluid communication with at least one inlet mouth 22 of the latter, and at least one valve 31, connected between the at least one deposition chamber 2 and the at least one vacuum pump 3, in fluid communication with them.

According to a further variant of the apparatus 100 of the present invention, contrary to what is illustrated in the Figures, the at least one inlet mouth 22 of the at least one deposition chamber 2 can be obtained at the bottom wall 21 of said deposition chamber, while the at least one outlet mouth 23 can be formed at the top of the at least one deposition chamber 2.

Finally, the temperature ranges indicated in the present description refer to the precursors for which they were provided. Clearly, these temperature ranges vary according to the Perovskite precursor to be deposited on each substrate 4.

### BIBLIOGRAPHICAL REFERENCES

[1] Luis K. Ono, Emilio J. Juarez-Perez, and Yabing Qi, ACS Appl. Mater. Interfaces, 2017, 9, 30197-30246.
[2] Burschka, N. Pellet, S.-J. Moon, R. Humphry-Baker, P. Gao, M. K. Nazeeruddin and M. Grätzel, Nature, 2013, 499, 316-9.
[3] N. J. Jeon, J. H. Noh, W. S. Yang, Y. C. Kim, S. Ryu, J. Seo and S. II Seok, Nature, 2015, 517, 476-480.
[4] A. K. Jena, A. Kulkarni, and T. Miyasaka, Chem. Rev., 2019, 119, 3036-3103.
[5] W. Huang, J. S. Manser, P. V. Kamat and S. Ptasinska, Chem. Mater., 2015, acs.chemmater.5b04122.
[6] M. Zhang, F. Yuan, W. Zhao, B. Jiao, C. Ran, W. Zhang and Z. Wu, Org. Electron. physics, Mater. Appl., 2018, 60, 57-63.
[7] V. Adinolfi, W. Peng, G. Walters, O. M. Bakr and E. H. Sargent, Adv. Mater., 2018, 30, 1-13.
[8] J. Zhou and J. Huang, Adv. Sci., 2018, 5.
[9] N. Patel, S. Dias and S. B. Krupanidhi, J. Electron. Mater., 2018, 47, 2306-2315.
[10] H. W. Chen, N. Sakai, A. K. Jena, Y. Sanehira, M. Ikegami, K.-C. Ho and T. Miyasaka, J. Phys. Chem. Lett., 2015, 6, 1773-1779.
[11] S. D. Stranks, G. E. Eperon, G. Grancini, C. Menelaou, M. J. P. Alcocer, T. Leijtens, L. M. Herz, A. Petrozza and H. J. Snaith, Science, 2013, 342, 341-344.
[12] A. Kojima, K. Teshima, Y. Shirai and T. Miyasaka, J. Am. Chem. Soc., 2009, 131, 6050-1
[13] W. S. Yang, B.-W. Park, E. H. Jung and N. J. Jeon, Science (80-.), 2017, 356, 1376-1379.
[14] https://www.nrel.gov/pv/assets/pdfs/best-research-cell-efficiencies.20200925.pdf
[15] Y. Zhao and K. Zhu, J. Phys. Chem. Lett., 2014, 5, 4175-4186.
[16] Yang, W. S., Noh, J. H., Jeon, N. J., Kim, Y. C., Ryu, S., Seo, J., & Seok, S. I. (2015). High-performance photovoltaic perovskite layers fabricated through intramolecular exchange. Science, 348(6240), 1234-1237. https://doi.org/10.1126/science.aaa9272
[17] A. Ng, Z. Ren, Q. Shen, S. H. Cheung, H. C. Gokkaya, S. K. So, A. B. Djurišić, Y. Wan, X. Wu and C. Surya, ACS Appl. Mater. Interfaces, 2016, 8, 32805-32814.
[18] Alberti, A.; Deretzis, I.; Mannino, G.; Smecca, E.; Giannazzo, F.; Listorti, A.; Colella, S.; Masi, S.; La Magna, A. Nitrogen soaking promotes lattice recovery in polycrystalline hybrid perovskites. Adv. Energy Mater. 2019, 9, 1803450.
[19] Alberti, A.; Deretzis, I.; Mannino, G.; Smecca, E.; Sanzaro, S.; Numata, Y.; Miyasaka, T.; La Magna, A. Revealing a discontinuity in the degradation behavior of CH3NH3Pbl3 during thermal operation. J. Phys. Chem. C 2017, 121, 13577-13585.
[20] Alberti, A.; Bongiorno, C.; Smecca, E.; Deretzis, I.; La Magna, A.; Spinella, C. Pb clustering and PbI2 nanofragmentation during methylammonium lead iodide perovskite degradation. Nat. Commun. 2019, 10, 2196.
[21] Giovanni Mannino, loannis Deretzis, Emanuele Smecca, Antonino La Magna, Alessandra Alberti, Davide Ceratti, David Cahen, Temperature-Dependent Optical Band Gap in CsPbBr3, MAPbBr3, and FAPbBr3 Single Crystals J. Phys. Chem. Lett. 2020, 11, 2490!2496.
[22] Alberti, A.; Smecca, E.; Sanzaro, S.; Mannino, G.; Deretzis, I.; La Magna, A. Hybrid perovskites for photovoltaics: Story, challenges and opportunities. Riv. Nuovo Cimento 2019, 7, 301-366.
[23] M. Liu, M. B. Johnston and H. J. Snaith, Nature, 2013, 501, 395-398.
[24] W. A. Dunlap-shohl, E. T. Barraza, A. Barrette, K. Gundogdu, D. Adrienne and D. B. Mitzi, 1-10.
[25] N. J. Jeon, J. H. Noh, W. S. Yang, Y. C. Kim, S. Ryu, J. Seo and S. II Seok, Nature, 2015, 517, 476-480.
[26] B. Danekamp, N. Droseros, F. Palazon, M. Sessolo, N. Banerji and H. J. Bolink. ACS Appl. Mater. Interfaces 2018, 10, 36187-36193.
[27] L.K. Ono, S. Wang, Y.Kato, S.R.Raga, Y.Qi, fabrication of semi-transparent perovskite films with centimiter scale superior uniformity by the hybrid deposition method, Energy Env.Sci, 7, 3989, 2014.
[28] ACS Applied Energy Mat. 2018, 1, 3843.
[29] Leilei Gu, Shubo Wang, Xiang Fang, Di Liu, Yibo Xu, Ningyi Yuan, and Jianning Ding High-Performance Large-Area Perovskite Solar Cells Enabled by Confined Space Sublimation ACS Appl. Mater. Interfaces 2020, 12, 33870-33878.
[30] Alessandra Alberti, loannis Deretzis, Giovanni Mannino, Emanuele Smecca, Filippo Giannazzo, Andrea Listorti, Silvia Colella, Sofia Masi, and Antonino La Magna; Adv. Energy Mater. 2019, 9, 1803450.

## Claims

1. Method (1) of deposition of at least one layer of at least one precursor of Perovskite on at least one substrate (4), through use of at least one deposition chamber (2), wherein:
- in said at least one deposition chamber (2) at least one inlet mouth (22) and at least one outlet mouth (23) are obtained, configured to be selectively opened-closed so as to allow the entrance-exit of at least one gas in-out of said at least one deposition chamber (2);
- said at least one deposition chamber (2), at said at least one outlet mouth (23) thereof, is operatively connected to at least one vacuum pump (3);
- said at least one deposition chamber (2) houses at least one source (5, 5'), said at least one source (5, 5') being configured to receive at least one precursor of said Perovskite without using a carrier gas, and said at least one source (5, 5') having at least one delivery mouth (51, 51'), configured to let one gas of said at least one precursor of said Perovskite, when it is sublimated into said source (5, 5'), pass directly from said at least one source (5, 5') into said at least one deposition chamber (2) without using a carrier gas; and
- said at least one deposition chamber (2) houses at least one supporting device (6) for said at least one substrate (4), said supporting device (6) being configured to support said substrate (4) between at least one working position, wherein said at least one substrate (4) is aligned with said at least one delivery mouth (51, 51') of said at least one source (5, 5'), at a preset deposition distance d_{w} therefrom, and one resting position, wherein it is spaced apart from said at least one delivery mouth (51, 51') of said at least one source (5, 5'), at a distance greater than said preset deposition distance d_{w};
and wherein
- said at least one substrate (4) is supported in said at least one deposition chamber (2) and said at least one precursor of said Perovskite is charged into said at least one source (5, 5') of said at least one deposition chamber (2) without using a carrier gas;
said method (1) comprising the following operational steps in sequence:
A. reducing pressure into said at least one deposition chamber (2), through activation of said vacuum pump (3), until one pressure value P_{c} comprised within a preset operational pressure interval ΔP_{c} is obtained, into said at least one deposition chamber (2);
B. sublimating said at least one precursor in said at least one source (5, 5'), until one gas of said at least one sublimated precursor is obtained;
C. if not yet in said working position, bringing said at least one substrate (4) in said working position and said at least one substrate (4) to one preset working temperature T_{w};
D. depositing said at least one gas of said at least one precursor thereby sublimated, said gas exiting said at least one source (5, 5') through said at least one delivery mouth (51, 51'), directly on said substrate (4) without using a carrier gas; and
E. cooling said at least one source (5, 5');
wherein
said preset operational pressure interval ΔP_{c} is between 0.1 x10⁻³ mbar and 100x10-³ mbar, optionally between 1x10⁻² mbar and 5x10⁻² mbar, more optionally between 2x10⁻² mbar and 4x10⁻² mbar and
wherein said preset deposition distance d_{w} is between 0.5 cm and 5 cm, optionally between 1 cm and 3 cm, more optionally comprised between 1.5 cm and 2.5 cm.

2. Method (1) according to claim 1, wherein said at least one delivery mouth (51, 51') is configured to be selectively opened-closed, wherein said step A occurs with said at least one delivery mouth (51, 51') closed and wherein said step D occurs with said at least one delivery mouth (51, 51') open.

3. Method (1) according to claim 1 or 2, wherein said step A further comprises feeding said at least one gas, optionally including one or more gases selected among the group comprising nitrogen, argon, neon, helium and hydrogen, into said at least one deposition chamber (2), through said at least one inlet mouth (22).

4. Method (1) according to claim 3, wherein said at least one pressure value P_{c} within said preset operational pressure interval ΔP_{c}, in said at least one deposition chamber (2), is obtained at said step A by:
- adjusting one feeding flux of said at least one gas into said at least one deposition chamber (2), optionally keeping one suction speed of said at least one vacuum pump (3) to the maximum; or
- through a constant feeding flux of said at least one gas into said at least one deposition chamber (2), and:
∘ an adjustment of one flow rate of at least one valve (31), optionally one throttle valve, through which said at least one deposition chamber (2) is operatively connected with said at least one vacuum pump (3); and/or
∘ an adjustment of one suction speed of said at least one vacuum pump (3), wherein optionally said adjustment of said suction speed of said at least one vacuum pump (3) is carried out continuously or at preset time intervals, in response to a measured value of said pressure P_{c} in said at least one deposition chamber (2).

5. Method (1) according to any previous claim, wherein in said step B, said at least one source (5, 5') is heated up to a source temperature Tₛ comprised between 70°C and 800°C, optionally between 80°C and 700°C, more optionally comprised between 100°C and 600°C and/or said at least one deposition chamber (2) is heated up to a temperature comprised between 40°C and 120°C, optionally between 50°C and 100°C, more optionally between 60°C and 80°C.

6. Method (1) according to any previous claim, wherein in said step C said at least one substrate (4) is heated up to one working temperature T_{w} comprised between 30°C and 300°C, optionally comprised between 50°C and 200°C, more optionally comprised between 60°C and 150°C.

7. Method (1) according to any previous claim, wherein if in said step A said at least one substrate (4) is in said working position, said method comprises cooling said at least one substrate (4), during said steps A and B, down to a temperature lower than one temperature that is required in said step B to sublimate said at least one precursor in said at least one source (5, 5').

8. Method (1) according to any previous claim, wherein before said step D the pressure difference ΔP_{sc} between said at least one source (5, 5') and said at least one deposition chamber (2) is equal to or greater than 1x10⁻² mbar.

9. Method (1) according to any previous claim, wherein before said step A, said method (1) comprises letting said at least one gas, optionally one ultra-pure gas, optionally nitrogen, or one noble gas as argon, neon or helium, flow through said at least one deposition chamber (2), from said at least one inlet mouth (22) thereof to said at least one outlet mouth (23) thereof.

10. Method (10) of deposition of at least one Perovskite layer on at least one substrate (4), comprising the following operational steps in sequence:
F. arranging at least one deposition chamber (2), wherein:
- in said at least one deposition chamber (2) at least one inlet mouth (22) and at least one outlet mouth (23) are obtained, configured to be selectively opened-closed so as to allow the entrance-exit of at least one gas in-out of said at least one deposition chamber (2);
- said at least one deposition chamber (2), at said at least one outlet mouth (23) thereof, is operatively connected to one vacuum pump (3);
- said at least one deposition chamber (2) houses at least one source (5, 5'), said at least one source (5, 5') being configured to receive at least one precursor of said Perovskite without using a carrier gas and said at least one source (5, 5') having at least one delivery mouth (51, 51'), to let one gas of said at least one precursor of said Perovskite, when it is sublimated into said source (5, 5'), pass directly from said at least one source (5, 5') into said at least one deposition chamber (2) without using a carrier gas; and
- said at least one deposition chamber (2) houses at least one supporting device (6) for said at least one substrate (4), said supporting device (6) being configured to support at least one substrate (4) between at least one working position, wherein said at least one substrate (4) is aligned with said at least one delivery mouth (51, 51') of said at least one source (5, 5'), at a preset deposition distance d_{w} therefrom, and one resting position, wherein it isspaced apart from said at least one delivery mouth (51, 51') of said at least one source (5, 5'), at a distance greater than said preset deposition distance d_{w};
and wherein
said substrate (4) is supported in said at least one deposition chamber (2) and said at least one precursor of said Perovskite is charged into said at least one source (5, 5') of said at least one deposition chamber (2) without using a carrier gas;
G. depositing at least one layer of said at least one precursor of said Perovskite on said at least one substrate (4), through method (1) according to any previous claim;
H. depositing at least one layer of said at least another precursor of said Perovskite on said at least one substrate (4), through method (1) according to any previous claim; and
I. if on said substrate (4), due to a chemical reaction between said at least one precursor and said at least another precursor of said Perovskite, the growth of said at least one layer of said Perovskite is obtained, interrupting the method; otherwise
J. going back to step H.

11. Method (10) according to claim 10, wherein:
- if in said at least one deposition chamber (2) only one source (5, 5') is housed, said method (10) comprises between said step G and said step H and/or, if applicable, between each step H and the next one, the substitution of said source (5, 5') in said at least one deposition chamber (2) containing said at least one precursor with another source (5', 5) containing said at least another precursor or the substitution, in said source (5, 5'), of said at least one precursor with said at least another precursor; or
- if said at least one deposition chamber (2) comprises two or more sources (5, 5'), said method (10) comprises charging said at least one precursor and said at least another precursor in a respective source (5, 5') and moving said substrate (4) between one source (5, 5') and the other, between said step G and said step H and/or, if applicable, between each step H and the next one; and
wherein
if said method is carried out in two or more deposition chambers (2), said method (10) can comprise moving said substrate (4) between one deposition chamber (2) and at least another deposition chamber (2), between said step G and said step H and/or, if applicable, between each step H and the next one.

12. Method (10) according to claim 10 or 11, wherein said pressure value (P_{c}) of said at least one deposition chamber (2), one pressure value (Pₛ) of said at least one source (5, 5'), said temperature value of said substrate T_{w} and said deposition distance d_{w}, within each step G and H, are adjusted in advance or continuously or at preset intervals during execution of said method.

13. Method (10) according to any claim 10 to 12, wherein after the execution of the last executed step H, said method comprises feeding into said at least one deposition chamber (2) at least one ultra-pure gas, optionally selected among the group comprising nitrogen or a noble gas comprised between argon, neon, or helium.

14. Method (10) according to any previous claim, wherein said at least one precursor and said at least another precursor are selected from the group comprising: PbI₂, MAI, FAI, Csl, SnI₂, PbCl₂, EuCl₃, EuI₂, in the form of powder or granules or tablets; and/or
wherein said substrate is made of one material selected from the group comprising glass, Silicon, PEN, PET, optionally provided with one surface layer of ITO or PTAA or FTO or TiO₂ or ZnO or said substrate is made of Aluminum, Titanium or Silicon Carbide.

15. Apparatus (100) for deposition, on at least one substrate (4), of at least one layer of at least one precursor of Perovskite or at least one layer of Perovskite, comprising:
- at least one vacuum pump (3);
- at least one deposition chamber (2) operatively connected to said at least one vacuum pump (3), in said at least one deposition chamber (2) at least one inlet mouth (22) and at least one outlet mouth (23) being obtained, each configured to be selectively opened-closed to allow the entrance-exit of at least one gas;
- at least one source (5, 5'), housed inside said at least one deposition chamber (2), said at least one source (5, 5') being configured to receive at least one precursor of said Perovskite without using a carrier gas and said at least one source (5, 5') having at least one delivery mouth (51, 51'), configured to let one gas of said at least one precursor of said Perovskite, when obtained into said source (5, 5'), pass directly from said at least one source (5, 5') into said at least one deposition chamber (2) without using a carrier gas;
- at least one supporting device (6) for said substrate (4), said supporting device (6) being housed into said at least one deposition chamber (2) and configured to support said substrate (4) between at least one working position, wherein said at least one substrate (4) is aligned with said at least one delivery mouth (51, 51') of said at least one source (5, 5'), at a preset deposition distance d_{w} therefrom, and one resting position, wherein it is spaced apart from said at least one delivery mouth (51, 51') of said at least one source (5, 5'), at a distance greater than said preset deposition distance d_{w};
- at least one control device, configured to control the selective opening-closing of said at least one inlet mouth (22) and at least one outlet mouth (23) obtained into said at least one deposition chamber (2), the movement, through said supporting device (6), of said substrate (4) between said working position and said resting position and between said at least one source (5) and said at least another source (5'), if provided in said at least one deposition chamber (2), or between said at least one deposition chamber (2) and said at least another deposition chamber (2), if provided in said apparatus (100), the activation of said vacuum pump (3), as well as to adjust one pressure value P_{c} of said at least one deposition chamber (2), one pressure value Pₛ of said at least one source (5, 5'), one temperature value of said substrate T_{w} and said deposition distance d_{w}, according to the method according to any previous claim.

16. Apparatus (100) according to claim 15, wherein said at least one source (5, 5') comprises one face facing, in use, said substrate (4), wherein one plurality of delivery mouths (51, 51') is obtained, optionally four, each delivery mouth (51, 51') having one optionally rectangular or oval or circular plant configuration, optionally having a size different from that of other delivery mouths of the plurality of delivery mouths (51, 51'), if circular, having a diameter optionally comprised between 0.5 cm and 1.25 cm, based on the geometry of the deposition chamber (2) and the number of sources (5, 5') comprised into said at least one deposition chamber (2), wherein the apparatus optionally comprises at least one shutter (7, 7') for each source (5, 5'), said shutter (7, 7') being configured to selectively open-close only one or more delivery mouths (51, 51') at the time, in sequence or simultaneously, keeping the remaining closed.

## Patentansprüche

1. Verfahren (1) zur Abscheidung mindestens einer Schicht mindestens eines Vorläufers von Perowskit auf mindestens einem Substrat (4) durch Verwendung mindestens einer Abscheidungskammer (2), wobei:
- in der mindestens einen Abscheidungskammer (2) mindestens eine Einlassöffnung (22) und mindestens eine Auslassöffnung (23) vorhanden sind, die so konfiguriert sind, dass sie selektiv geöffnet und geschlossen werden können, um den Ein- und Austritt mindestens eines Gases in die und aus der mindestens einen Abscheidungskammer (2) zu ermöglichen;
- die mindestens eine Abscheidungskammer (2) an ihrer mindestens einen Auslassöffnung (23) mit mindestens einer Vakuumpumpe (3) wirkverbunden ist;
- die mindestens eine Abscheidungskammer (2) mindestens eine Quelle (5, 5') enthält, wobei die mindestens eine Quelle (5, 5') so konfiguriert ist, dass sie mindestens einen Vorläufer des Perowskits ohne Verwendung eines Trägergases aufnimmt, und die mindestens eine Quelle (5, 5') mindestens eine Zuführungsöffnung (51, 51'), die so konfiguriert ist, dass sie ein Gas des mindestens einen Vorläufers des Perowskits, wenn es in die Quelle (5, 5') sublimiert wird, direkt von der mindestens einen Quelle (5, 5') in die mindestens eine Abscheidungskammer (2) ohne Verwendung eines Trägergases passieren lässt; und
- die mindestens eine Abscheidungskammer (2) mindestens eine Haltevorrichtung (6) für das mindestens eine Substrat (4) aufnimmt, wobei die Haltevorrichtung (6) so konfiguriert ist, dass sie das Substrat (4) zwischen mindestens einer Arbeitsposition, in der das mindestens eine Substrat (4) mit der mindestens einen Zuführungsöffnung (51, 5 1') der mindestens einen Quelle (5, 5') ausgerichtet ist, in einem vorgegebenen Ablagerungsabstand d_{W} davon, und einer Ruheposition, in der es von der mindestens einen Zuführungsöffnung (51, 51') der mindestens einen Quelle (5, 5') beabstandet ist, in einem Abstand, der größer ist als der vorgegebene Ablagerungsabstand d_{w}; und wobei
- das mindestens eine Substrat (4) in der mindestens einen Abscheidungskammer (2) gehalten wird und der mindestens eine Vorläufer des Perowskits in die mindestens eine Quelle (5, 5') der mindestens einen Abscheidungskammer (2) ohne Verwendung eines Trägergases eingefüllt wird, wobei das Verfahren (1) die folgenden aufeinanderfolgenden Arbeitsschritte umfasst:
A. Verringern des Drucks in der mindestens einen Abscheidungskammer (2) durch Aktivieren der Vakuumpumpe (3), bis ein Druckwert P_{c}, der in einem voreingestellten Betriebsdruckintervall ΔP_{c} enthalten ist, in der mindestens einen Abscheidungskammer (2) erreicht ist;
B. Sublimieren des mindestens einen Vorläufers in der mindestens einen Quelle (5, 5'), bis ein Gas des mindestens einen sublimierten Vorläufers erhalten wird;
C. falls sich das mindestens eine Substrat (4) noch nicht in der Arbeitsposition befindet, das mindestens eine Substrat (4) in die Arbeitsposition bringen und das mindestens eine Substrat (4) auf eine voreingestellte Arbeitstemperatur T_{W} bringen;
D. Abscheiden des mindestens einen Gases des mindestens einen Vorläufers, der dadurch sublimiert wird, wobei das Gas die mindestens eine Quelle (5, 5') durch die mindestens eine Abgabemündung (51, 51') direkt auf das Substrat (4) verlässt, ohne ein Trägergas zu verwenden; und
E. Abkühlen der mindestens einen Quelle (5, 5'); wobei das voreingestellte Betriebsdruckintervall ΔP_{c} zwischen 0,1 x 10⁻³ mbar und 100 x 10⁻³ mbar, optional zwischen 1 x 10⁻² mbar und 5 x 10⁻² mbar, optional zwischen 2x10⁻² mbar und 4x10⁻² mbar, und wobei die voreingestellte Ablagerungsentfernung d_{W} zwischen 0,5 cm und 5 cm, optional zwischen 1 cm und 3 cm, optional zwischen 1,5 cm und 2,5 cm liegt.

2. Verfahren (1) gemäß Anspruch 1, wobei die mindestens eine Abgabemündung (51, 51') so konfiguriert ist, dass sie selektiv geöffnet und geschlossen werden kann, wobei Schritt A bei geschlossener mindestens einer Abgabemündung (51, 51') stattfindet und wobei Schritt D bei geöffneter mindestens einer Abgabemündung (51, 51') stattfindet.

3. Verfahren (1) nach Anspruch 1 oder 2, wobei der Schritt A ferner das Zuführen des mindestens einen Gases, das gegebenenfalls ein oder mehrere Gase aus der Gruppe Stickstoff, Argon, Neon, Helium und Wasserstoff umfasst, in die mindestens eine Abscheidungskammer (2) durch die mindestens eine Einlassöffnung (22) umfasst.

4. Verfahren (1) nach Anspruch 3, wobei der mindestens eine Druckwert P_{C} innerhalb des voreingestellten Betriebsdruckintervalls ΔP_{C} in der mindestens einen Abscheidungskammer (2) in Schritt A erhalten wird durch:
- Einstellen eines Zufuhrflusses des mindestens einen Gases in die mindestens eine Abscheidungskammer
(2), gegebenenfalls Halten einer Sauggeschwindigkeit der mindestens einen Vakuumpumpe (3) auf dem Maximum; oder
durch einen konstanten Zufuhrfluss des mindestens einen Gases in die mindestens eine Abscheidungskammer (2) und:
∘ eine Einstellung einer Durchflussrate mindestens eines Ventils (31), optional eines Drosselventils, durch das die mindestens eine Abscheidungskammer (2) mit der mindestens einen Vakuumpumpe (3) wirkverbunden ist; und/oder
∘ eine Einstellung einer Sauggeschwindigkeit der mindestens einen Vakuumpumpe (3), wobei die Einstellung der Sauggeschwindigkeit der mindestens einen Vakuumpumpe (3) optional als Reaktion auf einen gemessenen Wert des Drucks P_{C} in der mindestens einen Abscheidungskammer (2) kontinuierlich oder in vorgegebenen Zeitintervallen durchgeführt wird.

5. Verfahren (1) gemäß einem der vorstehenden Ansprüche, wobei in Schritt B die mindestens eine Quelle (5, 5') auf eine Quellentemperatur T5 zwischen 70 °C und 800 °C, optional zwischen 80 °C und 700 °C, weiter optional zwischen 10 0 °C und 600 °C und/oder die mindestens eine Abscheidungskammer (2) auf eine Temperatur zwischen 40 °C und 120 °C, optional zwischen 50 °C und 100 °C, weiter optional zwischen 60 °C und 80 °C, aufgeheizt wird.

6. Verfahren (1) gemäß einem der vorherigen Ansprüche, wobei in Schritt C das mindestens eine Substrat (4) auf eine Arbeitstemperatur T zwischen 30 °C und 300 °C, gegebenenfalls zwischen 50 °C und 200 °C und weiter gegebenenfalls zwischen 60 °C und 150 °C, erhitzt wird.

7. Verfahren (1) gemäß einem beliebigen vorherigen Anspruch, wobei, wenn sich in Schritt A das mindestens eine Substrat (4) in der Arbeitsposition befindet, das Verfahren das Abkühlen des mindestens einen Substrats (4) während der Schritte A und B auf eine Temperatur umfasst, die niedriger ist als eine Temperatur, die in Schritt B erforderlich ist, um den mindestens einen Vorläufer in der mindestens einen Quelle (5, 5') zu sublimieren.

8. Verfahren (1) gemäß einem der vorherigen Ansprüche, wobei vor dem Schritt D die Druckdifferenz ΔP_{sc} zwischen der mindestens einen Quelle (5, 5') und der mindestens einen Abscheidungskammer (2) gleich oder größer als 1x10⁻² mbar ist.

9. Verfahren (1) gemäß einem beliebigen vorherigen Anspruch, wobei das Verfahren (1) vor dem Schritt A umfasst, dass das mindestens eine Gas, gegebenenfalls ein ultrareines Gas, gegebenenfalls Stickstoff, oder ein Edelgas wie Argon, Neon oder Helium, durch die mindestens eine Abscheidungskammer (2) von deren mindestens einer Einlassöffnung (22) zu deren mindestens einer Auslassöffnung (23) strömen gelassen wird.

10. Verfahren (10) zum Abscheiden mindestens einer Perowskitschicht auf mindestens einem Substrat (4), das die folgenden aufeinanderfolgenden Arbeitsschritte umfasst:
F. Anordnen mindestens einer Abscheidungskammer (2), wobei:
- in der mindestens einen Abscheidungskammer (2) mindestens eine Einlassöffnung (22) und mindestens eine Auslassöffnung (23) vorhanden sind, die so konfiguriert sind, dass sie selektiv geöffnet und geschlossen werden können, um den Ein- und Austritt mindestens eines Gases in die und aus der mindestens einen Abscheidungskammer (2) zu ermöglichen;
- die mindestens eine Abscheidungskammer (2) an ihrer mindestens einen Auslassöffnung (23) mit einer Vakuumpumpe (3) wirkverbunden ist;
- die mindestens eine Abscheidungskammer (2) mindestens eine Quelle (5, 5') beherbergt, wobei die mindestens eine Quelle (5, 5') so konfiguriert ist, dass sie mindestens einen Vorläufer des Perowskits ohne Verwendung eines Trägergases aufzunehmen, und wobei die mindestens eine Quelle (5, 5') mindestens eine Zuführungsöffnung (51, 51') aufweist, um ein Gas des mindestens einen Vorläufers des Perowskits, wenn es in der Quelle (5, 5') sublimiert wird, direkt von der mindestens einen Quelle (5, 5') in die mindestens eine Abscheidungskammer (2) ohne Verwendung eines Trägergases strömen zu lassen; und
- die mindestens eine Abscheidungskammer (2) mindestens eine Haltevorrichtung (6) für das mindestens eine Substrat (4) aufnimmt, wobei die Haltevorrichtung (6) so konfiguriert ist, dass sie mindestens ein Substrat (4) zwischen mindestens einer Arbeitsposition, in der das mindestens eine Substrat (4) auf die mindestens eine Zuführungsöffnung (51, 5 1') der mindestens einen Quelle (5, 5') ausgerichtet ist, in einem vorgegebenen Abscheidungsabstand d_{w} davon, und einer Ruheposition, in der es von der mindestens einen Abgabemündung (51, 51') der mindestens einen Quelle (5, 5') beabstandet ist, in einem Abstand, der größer ist als der vorgegebene Abscheidungsabstand d_{w};
und wobei das Substrat (4) in der mindestens einen Abscheidungskammer (2) gehalten wird und der mindestens eine Vorläufer des Perowskits in die mindestens eine Quelle (5, 5') der mindestens einen Abscheidungskammer (2) ohne Verwendung eines Trägergases geladen wird;
G. Abscheiden mindestens einer Schicht des mindestens einen Vorläufers des Perowskits auf dem mindestens einen Substrat (4) durch das Verfahren (1) gemäß einem beliebigen vorhergehenden Anspruch;
H. Abscheiden mindestens einer Schicht des mindestens anderen Vorläufers des Perowskits auf dem mindestens einen Substrat (4) durch das Verfahren (1) gemäß einem beliebigen vorhergehenden Anspruch; und
I. wenn auf dem Substrat (4) aufgrund einer chemischen Reaktion zwischen dem mindestens einen Vorläufer und dem mindestens anderen Vorläufer des Perowskits das Wachstum der mindestens einen Schicht des Perowskits erzielt wird, Unterbrechung des Verfahrens; andernfalls
J. Zurückgehen zu Schritt H.

11. Verfahren (10) gemäß Anspruch 10, wobei:
- wenn in der mindestens einen Abscheidungskammer (2) nur eine Quelle (5, 5') untergebracht ist, das Verfahren (10) zwischen dem Schritt G und dem Schritt H und/oder, falls zutreffend, zwischen jedem Schritt H und dem nächsten, den Austausch der Quelle (5 , 5') in der mindestens einen Abscheidungskammer (2), die den mindestens einen Vorläufer enthält, durch eine andere Quelle (5', 5), die den mindestens einen anderen Vorläufer enthält, oder durch den Austausch des mindestens einen Vorläufers in der Quelle (5, 5') durch den mindestens einen anderen Vorläufer; oder
- wenn die mindestens eine Abscheidungskammer (2) zwei oder mehr Quellen (5, 5') umfasst, umfasst das Verfahren (10) das Laden des mindestens einen Vorläufers und des mindestens anderen Vorläufers in eine jeweilige Quelle (5, 5') und das Bewegen des Substrats (4) zwischen einer Quelle (5, 5') und der anderen, zwischen dem Schritt G und dem Schritt H und/oder, falls zutreffend, zwischen jedem Schritt H und dem nächsten; und wobei
wenn das Verfahren in zwei oder mehr Abscheidungskammern (2) ausgeführt wird, das Verfahren (10) das Bewegen des Substrats (4) zwischen einer Abscheidungskammer (2) und mindestens einer anderen Abscheidungskammer (2), zwischen dem Schritt G und dem Schritt H und/oder, falls zutreffend, zwischen jedem Schritt H und dem nächsten umfassen kann.

12. Verfahren (10) nach Anspruch 10 oder 11, wobei der Druckwert (P_{C}) der mindestens einen Abscheidungskammer (2), ein Druckwert (P_{S}) der mindestens einen Quelle (5, 5'), der Temperaturwert des Substrats T und der Abscheidungsabstand d_{w} innerhalb jedes Schritts G und H im Voraus oder kontinuierlich oder in voreingestellten Intervallen während der Ausführung des Verfahrens eingestellt werden.

13. Verfahren (10) gemäß einem der Ansprüche 10 bis 12, wobei das Verfahren nach der Ausführung des zuletzt ausgeführten Schritts H das Zuführen von mindestens einem ultrareinen Gas in die mindestens eine Abscheidungskammer (2) umfasst, wobei das Gas optional aus der Gruppe ausgewählt wird, die Stickstoff oder ein Edelgas umfasst, das aus Argon, Neon oder Helium besteht.

14. Verfahren (10) gemäß einem der vorhergehenden Ansprüche, wobei der mindestens eine Vorläufer und der mindestens eine andere Vorläufer aus der Gruppe ausgewählt sind, die Folgendes umfasst: PbI₂, MAI, FAI, Csl, SnI₂, PbCl₂, EuCl₃, EuI₂, in Form von Pulver, Granulat oder Tabletten; und/oder
wobei das Substrat aus einem Material besteht, das aus der Gruppe ausgewählt ist, die Glas, Silizium, PEN, PET umfasst, und optional mit einer Oberflächenschicht aus ITO oder PTAA oder FTO oder TiO₂ oder ZnO versehen ist, oder das Substrat aus Aluminium, Titan oder Siliziumkarbid besteht.

15. Vorrichtung (100) zur Abscheidung mindestens einer Schicht mindestens eines Perowskit-Vorläufers oder mindestens einer Perowskit-Schicht auf mindestens einem Substrat (4), umfassend:
- mindestens eine Vakuumpumpe (3);
- mindestens eine Abscheidungskammer (2), die mit der mindestens einen Vakuumpumpe (3) in Wirkverbindung steht, wobei in der mindestens einen Abscheidungskammer (2) mindestens eine Einlassöffnung (22) und mindestens eine Auslassöffnung (23) vorhanden sind, die jeweils so konfiguriert sind, dass sie selektiv geöffnet und geschlossen werden können, um den Ein- und Austritt mindestens eines Gases zu ermöglichen;
- mindestens eine Quelle (5, 5'), die in der mindestens einen Abscheidungskammer (2) untergebracht ist, wobei die mindestens eine Quelle (5, 5') so konfiguriert ist, dass sie mindestens einen Vorläufer des Perowskits ohne Verwendung eines Trägergases aufnimmt, und wobei die mindestens eine Quelle (5, 5') mindestens eine Zuführungsöffnung (51, 51'), die so konfiguriert ist, dass sie ein Gas des mindestens einen Vorläufers des Perowskits, wenn es in der Quelle (5, 5') erhalten wird, direkt von der mindestens einen Quelle (5, 5') in die mindestens eine Abscheidungskammer (2) ohne Verwendung eines Trägergases passieren lässt;
- mindestens eine Haltevorrichtung (6) für das Substrat (4), wobei die Haltevorrichtung (6) in der mindestens einen Abscheidungskammer (2) untergebracht und so konfiguriert ist, dass sie das Substrat (4) zwischen mindestens einer Arbeitsposition, in der das mindestens eine Substrat (4) mit der mindestens einen Zuführungsöffnung (51, 51') der mindestens einen Quelle (5, 5') ausgerichtet ist, in einem vorgegebenen Abscheidungsabstand d_{w} davon, und einer Ruheposition hält, in der es von der mindestens einen Zuführungsöffnung (51, 51') der mindestens einen Quelle (5, 5') beabstandet ist, ') der mindestens einen Quelle (5, 5') ausgerichtet ist, in einem vorgegebenen Abscheidungsabstand d_{w} davon, und einer Ruheposition, in der sie von der mindestens einen Zuführungsöffnung (51, 51') der mindestens einen Quelle (5, 5') beabstandet ist, in einem Abstand, der größer ist als der vorgegebene Abscheidungsabstand d_{w};
- mindestens eine Steuervorrichtung, die so konfiguriert ist, dass sie das selektive Öffnen und Schließen der mindestens einen Einlassöffnung (22) und mindestens einer Auslassöffnung (23) in der mindestens einen Abscheidekammer (2) steuert, wobei die Bewegung des Substrats (4) durch die Stützvorrichtung (6) zwischen der Arbeitsposition und der der Ruheposition und zwischen der mindestens einen Quelle (5) und der mindestens anderen Quelle (5'), falls in der mindestens einen Abscheidungskammer (2) vorgesehen, oder zwischen der mindestens einen Abscheidungskammer (2) und der mindestens anderen Abscheidungskammer (2), falls in der Vorrichtung (100) vorgesehen, die Aktivierung der Vakuumpumpe (3) sowie zur Einstellung eines Druckwertes P_{C} der mindestens einen Abscheidungskammer (2), eines Druckwertes P_{S} der mindestens einen Quelle (5, 5'), eines Temperaturwertes des Substrats T und des Abscheidungsabstandes d_{w} gemäß dem Verfahren gemäß einem beliebigen vorhergehenden Anspruch.

16. Vorrichtung (100) nach Anspruch 15, wobei die mindestens eine Quelle (5, 5') eine Fläche umfasst, die im Gebrauch dem Substrat (4) zugewandt ist, wobei eine Vielzahl von Zuführungsöffnungen (51, 51'), optional vier, erhalten wird, wobei jede Zuführungsöffnung (51, 51') eine optional rechteckige, ovale oder kreisförmige Pflanzenkonfiguration aufweist, die sich gegebenenfalls in der Größe von den anderen Abgabemündungen der Vielzahl von Abgabemündungen (51, 51') unterscheidet, und, wenn sie kreisförmig ist, einen Durchmesser aufweist, der gegebenenfalls zwischen 0,5 cm und 1,25 cm liegt, basierend auf der Geometrie der Ablagerungskammer (2) und der Anzahl der Quellen (5, 5'), die in der mindestens einen Abscheidungskammer (2) umfasst, wobei die Vorrichtung optional mindestens einen Verschluss (7, 7') für jede Quelle (5, 5') umfasst, wobei der Verschluss (7, 7') so konfiguriert ist, dass er selektiv nur eine oder mehrere Zuführungsöffnungen (51, 51') gleichzeitig öffnet und schließt, nacheinander oder gleichzeitig, wobei die übrigen geschlossen bleiben.

## Revendications

1. Procédé (1) de dépôt d'au moins une couche d'au moins un précurseur de Pérovskite sur au moins un substrat (4), par utilisation d'au moins une chambre de dépôt (2), dans lequel:
- dans ladite au moins une chambre de dépôt (2), au moins une embouchure d'entrée (22) et au moins une embouchure de sortie (23) sont obtenues, configurées pour être sélectivement ouvertes-fermées de manière à permettre l'entrée-sortie d'au moins un gaz dans/de ladite au moins une chambre de dépôt (2);
- ladite au moins une chambre de dépôt (2), au niveau de ladite au moins une embouchure de sortie (23) de celle-ci, est reliée de manière fonctionnelle à au moins une pompe à vide (3);
- ladite au moins une chambre de dépôt (2) abrite au moins une source (5, 5'), ladite au moins une source (5, 5') étant configurée pour recevoir au moins un précurseur de ladite Pérovskite sans utiliser de gaz porteur, et ladite au moins une source (5, 5') ayant au moins une embouchure de distribution (51, 51'), configurée pour laisser un gaz dudit au moins un précurseur de ladite Pérovskite, lorsqu'il est sublimé dans ladite source (5, 5'), passer directement de ladite au moins une source (5, 5') dans ladite au moins une chambre de dépôt (2) sans utiliser de gaz porteur; et
- ladite au moins une chambre de dépôt (2) abrite au moins un dispositif de support (6) pour ledit au moins un substrat (4), ledit dispositif de support (6) étant configuré pour supporter ledit substrat (4) entre au moins une position de travail, dans laquelle ledit au moins un substrat (4) est aligné avec ladite au moins une embouchure de distribution (51, 51') de ladite au moins une source (5, 5'), à une distance de dépôt prédéfinie d_{w} de celle-ci, et une position de repos, dans laquelle il est espacé de ladite au moins une embouchure de distribution (51, 51') de ladite au moins une source (5, 5'), à une distance supérieure à ladite distance de dépôt prédéfinie d_{w};
et dans lequel
- ledit au moins un substrat (4) est supporté dans ladite au moins une chambre de dépôt (2) et ledit au moins un précurseur de ladite Pérovskite est chargé dans ladite au moins une source (5, 5') de ladite au moins une chambre de dépôt (2) sans utiliser de gaz porteur;
ledit procédé (1) comprenant les étapes fonctionnelles suivantes en séquence:
A. réduction de la pression dans ladite au moins une chambre de dépôt (2), par l'activation de ladite pompe à vide (3), jusqu'à obtenir une valeur de pression P_{c} comprise dans un intervalle de pression fonctionnelle prédéfini ΔP_{c}, dans ladite au moins une chambre de dépôt (2);
B. sublimation dudit au moins un précurseur dans ladite au moins une source (5, 5'), jusqu'à obtenir un gaz dudit au moins un précurseur sublimé;
C. s'il n'est pas encore dans ladite position de travail, mise dudit au moins un substrat (4) dans ladite position de travail et dudit au moins un substrat (4) à une température de travail prédéfinie T_{w;}
D. dépôt dudit au moins un gaz dudit au moins un précurseur ainsi sublimé, ledit gaz sortant de ladite au moins une source (5, 5') par ladite au moins une embouchure de distribution (51, 51'), directement sur ledit substrat (4) sans utiliser de gaz porteur; et
E. refroidissement de ladite au moins une source (5, 5');
dans lequel
ledit intervalle de pression fonctionnelle prédéfini ΔP_{c} est compris entre 0,1×10⁻³ mbar et 100×10⁻³ mbar, facultativement entre 1×10⁻² mbar et 5×10⁻² mbar, plus facultativement entre 2×10⁻² mbar et 4×10⁻² mbar et
dans lequel ladite distance de dépôt prédéfinie d_{w} est comprise entre 0,5 cm et 5 cm, facultativement entre 1 cm et 3 cm, plus facultativement comprise entre 1,5 cm et 2,5 cm.

2. Procédé (1) selon la revendication 1, dans lequel ladite au moins une embouchure de distribution (51, 51') est configurée pour être ouverte-fermée de manière sélective, dans lequel ladite étape A se produit avec ladite au moins une embouchure de distribution (51, 51') fermée et dans lequel ladite étape D se produit avec ladite au moins une embouchure de distribution (51, 51') ouverte.

3. Procédé (1) selon la revendication 1 ou 2, dans lequel ladite étape A comprend en outre l'alimentation dudit au moins un gaz, facultativement comprenant un ou plusieurs gaz choisis dans le groupe comprenant l'azote, l'argon, le néon, l'hélium et l'hydrogène, dans ladite au moins une chambre de dépôt (2), à travers ladite au moins une embouchure d'entrée (22).

4. Procédé (1) selon la revendication 3, dans lequel ladite au moins une valeur de pression P_{c} dans ledit intervalle de pression fonctionnelle prédéfini ΔP_{c}, dans ladite au moins une chambre de dépôt (2), est obtenue à ladite étape A par:
- réglage d'un flux d'alimentation dudit au moins un gaz dans ladite au moins une chambre de dépôt (2), facultativement en maintenant une vitesse d'aspiration de ladite au moins une pompe à vide (3) au maximum; ou
- par un flux d'alimentation constant dudit au moins un gaz dans ladite au moins une chambre de dépôt (2), et:
∘ un réglage d'un débit d'au moins une vanne (31), facultativement une vanne d'étranglement, par l'intermédiaire de laquelle ladite au moins une chambre de dépôt (2) est reliée de manière fonctionnelle à ladite au moins une pompe à vide (3); et/ou
∘ un réglage d'une vitesse d'aspiration de ladite au moins une pompe à vide (3), où facultativement ledit réglage de ladite vitesse d'aspiration de ladite au moins une pompe à vide (3) est effectué en continu ou à des intervalles de temps prédéfinis, en réponse à une valeur mesurée de ladite pression P_{c} dans ladite au moins une chambre de dépôt (2).

5. Procédé (1) selon l'une des revendications précédentes, dans lequel dans ladite étape B, ladite au moins une source (5, 5') est chauffée jusqu'à une température de source Tₛ comprise entre 70°C et 800°C, facultativement entre 80°C et 700°C, plus facultativement comprise entre 100°C et 600°C et/ou ladite au moins une chambre de dépôt (2) est chauffée jusqu'à une température comprise entre 40°C et 120°C, facultativement entre 50°C et 100°C, plus facultativement entre 60°C et 80°C.

6. Procédé (1) selon l'une des revendications précédentes, dans lequel, dans ladite étape C, ledit au moins un substrat (4) est chauffé jusqu'à une température de travail T_{w} comprise entre 30°C et 300°C, facultativement comprise entre 50°C et 200°C, plus facultativement comprise entre 60°C et 150°C.

7. Procédé (1) selon l'une des revendications précédentes, dans lequel si dans ladite étape A ledit au moins un substrat (4) est dans ladite position de travail, ledit procédé comprend le refroidissement dudit au moins un substrat (4), pendant lesdites étapes A et B, jusqu'à une température inférieure à une température qui est requise dans ladite étape B pour sublimer ledit au moins un précurseur dans ladite au moins une source (5, 5').

8. Procédé (1) selon l'une des revendications précédentes, dans lequel avant ladite étape D, la différence de pression ΔP_{sc} entre ladite au moins une source (5, 5') et ladite au moins une chambre de dépôt (2) est supérieure ou égale à 1×10⁻² mbar.

9. Procédé (1) selon l'une des revendications précédentes, dans lequel, avant ladite étape A, ledit procédé (1) comprend le fait de laisser ledit au moins un gaz, facultativement un gaz ultra-pur, facultativement de l'azote, ou un gaz noble tel que l'argon, le néon ou l'hélium, s'écouler à travers ladite au moins une chambre de dépôt (2), depuis ladite au moins une embouchure d'entrée (22) de celle-ci jusqu'à ladite au moins une embouchure de sortie (23) de celle-ci.

10. Procédé (10) de dépôt d'au moins une couche de Pérovskite sur au moins un substrat (4), comprenant les étapes fonctionnelles suivantes en séquence:
F. agencement d'au moins une chambre de dépôt (2), où:
- dans ladite au moins une chambre de dépôt (2), au moins une embouchure d'entrée (22) et au moins une embouchure de sortie (23) sont obtenues, configurées pour être sélectivement ouvertes-fermées de manière à permettre l'entrée-sortie d'au moins un gaz dans/de ladite au moins une chambre de dépôt (2);
- ladite au moins une chambre de dépôt (2), au niveau de ladite au moins une embouchure de sortie (23) de celle-ci, est reliée de manière fonctionnelle à une pompe à vide (3);
- ladite au moins une chambre de dépôt (2) abrite au moins une source (5, 5'), ladite au moins une source (5, 5') étant configurée pour recevoir au moins un précurseur de ladite Pérovskite sans utiliser de gaz porteur et ladite au moins une source (5, 5') ayant au moins une embouchure de distribution (51, 51'), pour laisser un gaz dudit au moins un précurseur de ladite Pérovskite, lorsqu'il est sublimé dans ladite source (5, 5'), passer directement de ladite au moins une source (5, 5') dans ladite au moins une chambre de dépôt (2) sans utiliser de gaz porteur; et
- ladite au moins une chambre de dépôt (2) abrite au moins un dispositif de support (6) pour ledit au moins un substrat (4), ledit dispositif de support (6) étant configuré pour supporter au moins un substrat (4) entre au moins une position de travail, dans laquelle ledit au moins un substrat (4) est aligné avec ladite au moins une embouchure de distribution (51, 51') de ladite au moins une source (5, 5'), à une distance de dépôt prédéfinie d_{w} de celle-ci, et une position de repos, dans laquelle il est espacé de ladite au moins une embouchure de distribution (51, 51') de ladite au moins une source (5, 5'), à une distance supérieure à ladite distance de dépôt prédéfinie d_{w;}
et où
ledit substrat (4) est supporté dans ladite au moins une chambre de dépôt (2) et ledit au moins un précurseur de ladite Pérovskite est chargé dans ladite au moins une source (5, 5') de ladite au moins une chambre de dépôt (2) sans utiliser de gaz porteur;
G. dépôt d'au moins une couche dudit au moins un précurseur de ladite Pérovskite sur ledit au moins un substrat (4), par le procédé (1) selon l'une des revendications précédentes;
H. dépôt d'au moins une couche dudit au moins un autre précurseur de ladite Pérovskite sur ledit au moins un substrat (4), par le procédé (1) selon l'une des revendications précédentes; et
I. si sur ledit substrat (4), du fait d'une réaction chimique entre ledit au moins un précurseur et ledit au moins un autre précurseur de ladite Pérovskite, la croissance de ladite au moins une couche de ladite Pérovskite est obtenue, interruption du procédé; sinon
J. retour à l'étape H.

11. Procédé (10) selon la revendication 10, dans lequel:
- si dans ladite au moins une chambre de dépôt (2) une seule source (5, 5') est logée, ledit procédé (10) comprend entre ladite étape G et ladite étape H et/ou, le cas échéant, entre chaque étape H et la suivante, la substitution de ladite source (5, 5') dans ladite au moins une chambre de dépôt (2) contenant ledit au moins un précurseur par une autre source (5', 5) contenant ledit au moins un autre précurseur ou la substitution, dans ladite source (5, 5'), dudit au moins un précurseur par ledit au moins un autre précurseur; ou
- si ladite au moins une chambre de dépôt (2) comprend deux sources (5, 5') ou plus, ledit procédé (10) comprend le chargement dudit au moins un précurseur et dudit au moins un autre précurseur dans une source respective (5, 5') et le déplacement dudit substrat (4) entre une source (5, 5') et l'autre, entre ladite étape G et ladite étape H et/ou, le cas échéant, entre chaque étape H et la suivante; et
dans lequel
si ledit procédé est mis en œuvre dans deux chambres de dépôt (2) ou plus, ledit procédé (10) peut comprendre le déplacement dudit substrat (4) entre une chambre de dépôt (2) et au moins une autre chambre de dépôt (2), entre ladite étape G et ladite étape H et/ou, le cas échéant, entre chaque étape H et la suivante.

12. Procédé (10) selon la revendication 10 ou 11, dans lequel ladite valeur de pression (P_{c}) de ladite au moins une chambre de dépôt (2), une valeur de pression (Pₛ) de ladite au moins une source (5, 5'), ladite valeur de température dudit substrat T_{w} et ladite distance de dépôt d_{w}, dans chaque étape G et H, sont réglées à l'avance ou en continu ou à des intervalles prédéfinis pendant l'exécution dudit procédé.

13. Procédé (10) selon l'une des revendications 10 à 12, dans lequel après l'exécution de la dernière étape H exécutée, ledit procédé comprend l'alimentation de ladite au moins une chambre de dépôt (2) en au moins un gaz ultra-pur, facultativement choisi dans le groupe comprenant l'azote ou un gaz noble compris entre l'argon, le néon ou l'hélium.

14. Procédé (10) selon l'une des revendications précédentes, dans lequel ledit au moins un précurseur et ledit au moins un autre précurseur sont choisis dans le groupe comprenant: PbI₂, MAI, FAI, Csl, SnI₂, PbCl₂, EuCl₃, EuI₂, sous forme de poudre ou de granulés ou de comprimés; et/ou
dans lequel ledit substrat est constitué d'un matériau choisi dans le groupe comprenant le verre, le silicium, le PEN, le PET, facultativement pourvu d'une couche de surface d'ITO ou de PTAA ou de FTO ou de TiO₂ ou de ZnO ou ledit substrat est constitué d'aluminium, de titane ou de carbure de silicium.

15. Appareil (100) de dépôt, sur au moins un substrat (4), d'au moins une couche d'au moins un précurseur de Pérovskite ou d'au moins une couche de Pérovskite, comprenant:
- au moins une pompe à vide (3);
- au moins une chambre de dépôt (2) reliée de manière fonctionnelle à ladite au moins une pompe à vide (3), dans ladite au moins une chambre de dépôt (2) au moins une embouchure d'entrée (22) et au moins une embouchure de sortie (23) étant obtenues, chacune configurée pour être sélectivement ouverte-fermée pour permettre l'entrée-sortie d'au moins un gaz;
- au moins une source (5, 5'), logée à l'intérieur de ladite au moins une chambre de dépôt (2), ladite au moins une source (5, 5') étant configurée pour recevoir au moins un précurseur de ladite Pérovskite sans utiliser de gaz porteur et ladite au moins une source (5, 5') ayant au moins une embouchure de distribution (51, 51'), configurée pour laisser un gaz dudit au moins un précurseur de ladite Pérovskite, lorsqu'il est obtenu dans ladite source (5, 5'), passer directement de ladite au moins une source (5, 5') dans ladite au moins une chambre de dépôt (2) sans utiliser de gaz porteur;
- au moins un dispositif de support (6) pour ledit substrat (4), ledit dispositif de support (6) étant logé dans ladite au moins une chambre de dépôt (2) et configuré pour supporter ledit substrat (4) entre au moins une position de travail, dans laquelle ledit au moins un substrat (4) est aligné avec ladite au moins une embouchure de distribution (51, 51') de ladite au moins une source (5, 5'), à une distance de dépôt prédéfinie d_{w} de celle-ci, et une position de repos, dans laquelle il est espacé de ladite au moins une embouchure de distribution (51, 51') de ladite au moins une source (5, 5'), à une distance supérieure à ladite distance de dépôt prédéfinie d_{w};
- au moins un dispositif de commande, configuré pour commander l'ouverture-fermeture sélective de ladite au moins une embouchure d'entrée (22) et de ladite au moins une embouchure de sortie (23) obtenues dans ladite au moins une chambre de dépôt (2), le déplacement, à travers ledit dispositif de support (6), dudit substrat (4) entre ladite position de travail et ladite position de repos et entre ladite au moins une source (5) et ladite au moins une autre source (5'), si elle est prévue dans ladite au moins une chambre de dépôt (2), ou entre ladite au moins une chambre de dépôt (2) et ladite au moins une autre chambre de dépôt (2), si elle est prévue dans ledit appareil (100), l'activation de ladite pompe à vide (3), ainsi que pour régler une valeur de pression P_{c} de ladite au moins une chambre de dépôt (2), une valeur de pression Pₛ de ladite au moins une source (5, 5'), une valeur de température dudit substrat T_{w} et ladite distance de dépôt d_{w}, selon le procédé selon l'une des revendications précédentes.

16. Appareil (100) selon la revendication 15, dans lequel ladite au moins une source (5, 5') comprend une face tournée, lors de l'utilisation, vers ledit substrat (4), dans lequel une pluralité d'embouchures de distribution (51, 51') est obtenue, facultativement quatre, chaque embouchure de distribution (51, 51') ayant une configuration d'installation facultativement rectangulaire ou ovale ou circulaire, facultativement ayant une taille différente de celle des autres embouchures de distribution de la pluralité d'embouchures de distribution (51, 51'), si elle est circulaire, ayant un diamètre facultativement compris entre 0,5 cm et 1,25 cm, sur la base de la géométrie de la chambre de dépôt (2) et du nombre de sources (5, 5') comprises dans ladite au moins une chambre de dépôt (2), où l'appareil comprend facultativement au moins un obturateur (7, 7') pour chaque source (5, 5'), ledit obturateur (7, 7') étant configuré pour ouvrir-fermer sélectivement uniquement une ou plusieurs embouchures de distribution (51, 51') à la fois, en séquence ou simultanément, en maintenant les autres fermées.
